## Europäisches Patentamt

## European Patent Office

## Office européen des brevets

(19)

(11) **EP 1 135 694 B1**

(12) **EUROPÄISCHE PATENTSCHRIFT**

(45) Veröffentlichungstag und Bekanntmachung des Hinweises auf die Patenterteilung:
**02.01.2004 Patentblatt 2004/01**

(21) Anmeldenummer: **00972574.8**

(22) Anmeldetag: **05.09.2000**

(51) Int Cl.7: **G01R 33/035**

(86) Internationale Anmeldenummer:
**PCT/DE2000/003034**

(87) Internationale Veröffentlichungsnummer:
**WO 2001/025805 (12.04.2001 Gazette 2001/15)**

(54) **VORRICHTUNG ZUR HOCHAUFLÖSENDEN MESSUNG VON MAGNETISCHEN FELDERN**

DEVICE FOR HIGH RESOLUTION MEASUREMENT OF MAGNETIC FIELDS

DISPOSITIF POUR LA MESURE A HAUTE RESOLUTION DE CHAMPS MAGNETIQUES

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **04.10.1999 DE 19947615**

(43) Veröffentlichungstag der Anmeldung:
**26.09.2001 Patentblatt 2001/39**

(73) Patentinhaber: **QEST Quantenelektronische Systeme Tübingen GmbH Sitz Böblingen 71034 Böblingen (DE)**

(72) Erfinder:
 • **Schopohl, Nils**
   **72766 Reutlingen (DE)**
 • **Häussler, Christoph**
   **70569 Stuttgart (DE)**
 • **Oppenländer, Jörg**
   **72138 Kirchentellinsfurt (DE)**

(74) Vertreter: **Roth, Klaus, Dr. et al**
**Patentanwälte**
**Eisele, Otten, Roth & Dobler,**
**Karlstrasse 8**
**88212 Ravensburg (DE)**

(56) Entgegenhaltungen:
**WO-A-96/39635**      **US-A- 5 326 986**
**US-A- 5 574 290**

 • **PATENT ABSTRACTS OF JAPAN vol. 006, no. 229 (P-155), 16. November 1982 (1982-11-16) -& JP 57 132072 A (TOUHOKU KINZOKU KOGYO KK), 16. August 1982 (1982-08-16)**
 • **HAEUSSLER CH. ET AL: 'Nonperiodic flux to voltage conversion of series arrays of dc superconducting quantum interference devices' J.APPL.PHYS. Bd. 89, Nr. 3, 2001, Seiten 1875 - 1879**
 • **OPPENLAENDER J. ET AL: 'Highly sensitive magnetometers for absolute magnetic field measurements based on quantum interference filters' PHYSICA C Bd. 368, 2002, Seiten 119 - 124**

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft eine Vorrichtung zur hochauflösenden Messung, insbesondere zur hochauflösenden absoluten Messung von magnetischen Feldern gemäß dem Oberbegriff des Anspruchs 1.

Stand der Technik

Das Messprinzip beruht auf dem physikalischen Effekt der makroskopischen Quanten-Interferenz, wie er bei geschlossenen Stromkreisen aus supraleitenden Materialien auftritt, die durch Josephson-Tunnel-Kontakte oder allgemein, sogenannte weak-links, miteinander verkoppelt sind.

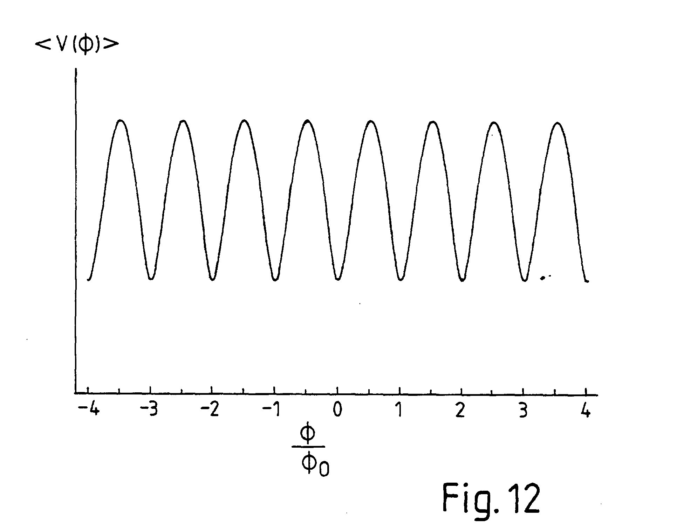

Es ist bekannt, dass einfach geschlossene supraleitende Stromkreise, die Josephsonkontakte oder weak-links enthalten, zur Messung sehr kleiner Magnetfeldänderungen bis in den Bereich von fT ($10^{-15}$ Tesla) verwendet werden können. Bei den dem Stand der Technik entsprechenden Vorrichtungen, den sogenannten SQUIDs (Superconducting Quantum Interference Devices), werden einfach geschlossene supraleitende Stromschlaufen verwendet, welche üblicherweise zwei, in vereinzelten Anwendungen auch mehr Josephsonkontakte enthalten. Sofern diese Stromschlaufen mit einem Strom getrieben werden, der unter einem kritischen Strom liegt, fällt an den Kontakten keine Spannung ab. In modernen SQUIDs werden die Stromschlaufen jedoch durch einen zeitlich konstanten überkritischen Strom getrieben, so dass zwischen den beiden supraleitenden Elektroden zu beiden Seiten der Kontakte eine sich zeitlich schnell ändernde Wechselspannung abfällt. Die Frequenz dieser Wechselspannung hängt von der Stärke des treibenden Stromes $I_0$ und der Stärke des magnetischen Flusses $\Phi=B_\perp F$ ab, der die Schlaufe durchsetzt, wobei $B_\perp$ die auf der Fläche $F$ des SQUIDs senkrecht stehende Komponente des vektoriellen Magnetfelds $\vec{B}$ bezeichnet. Als einfach zugängliche Messgröße dient die über der Stromschlaufe abfallende Gleichspannung $\langle V(\vec{B};I_0)\rangle$, welche durch zeitliche Mittelung der sich schnell ändernden Wechselspannung über eine oder mehrere Perioden entsteht. Die Eichkurve $\langle V(\vec{B};I_0)\rangle$ eines solchen typischen zwei Kontakt dc-SQUIDs ist in Abb. 12 skizziert. Immer dann, wenn der Fluss $\Phi$, der die Schlaufe durchsetzt, einem ganzzahligen Vielfachen des elementaren Flussquants $\Phi_0 = \frac{h}{2e} \cong 2\times10^{-15}\ Tm^2$ entspricht, nimmt die Eichkurve ein Minimum an, für halbzahlige Vielfache des elementaren Flussquants $\Phi_0$ hingegen ein Maximum. Die Eichkurven aller bisher bekannten SQUID-Systeme besitzen eine solche Periodizität. Bei bekannter Fläche $F$ der Stromschlaufe kann die zu dieser Fläche senkrecht stehende Komponente der magnetischen Induktion $\vec{B}$ bis auf ganzzahlige Vielfache von $\Phi_0$ bestimmt werden, d. h. es kann daher prinzipiell nur $\Phi$mod $\Phi_0$ gemessen werden. Wegen der Periodizität der Eichkurve $\langle V(\vec{B};I_0)\rangle$ können herkömmliche SQUIDs daher nicht zur absoluten quantitativen Präzisionsmessung der magnetischen Induktion $\vec{B}$ verwendet werden. Hierzu bedarf es zur Zeit der sehr aufwendigen und kostspieligen Kombination mit anderen physikalischen Messverfahren, wie etwa der Verbindung mit optisch gepumpten Magnetometern. Die kommerziellen Anwendungsgebiete von SQUIDs sind dementsprechend beschränkt auf die Detektion räumlicher oder zeitlicher, relativer Feldänderungen, wie sie etwa bei der Materialprüfung oder der Untersuchung von Stoffwechselvorgängen in biologischen Organismen auftreten. Auch bei diesen Anwendungen muss allerdings die Größenordnung der Feldänderungen im vornherein bekannt sein, wenn die Messung mehr als nur rein qualitative Aussagen oder grobe Abschätzungen ermöglichen soll.

JP-A- 57 132 072 , US-A- 5, 326, 986, WO-A- 96/39635 und US-A- 5, 574, 290 beschreiben herkömmliche SQUId-Netzwerke.

Aufgabe der Erfindung ist es, eine einfache Vorrichtung zu schaffen, die die hochpräzise absolute Messung von insbesondere auch zeitveränderlichen magnetischen Feldern ermöglicht und dabei in vollem Umfang auf die für herkömmliche SQUIDs entwickelte Kryotechnologie zurückgreifen kann.

Diese Aufgabe wird durch eine Vorrichtung nach dem Anspruch 1 gelöst.

Die Erfindung geht von einer Vorrichtung zur hochauflösenden Messung, insbesondere zur hochauflösenden absoluten Messung von magnetischen, insbesondere zeitveränderlichen magnetischen Feldern aus, die ein Netzwerk von Übergängen zwischen Supraleitern, die Josephson-Effekte zeigen, im Folgenden "Kontakte" genannt, umfasst, wobei das Netzwerk geschlossene Maschen, im Folgenden mit Zellen bezeichnet, besitzt, die jeweils mindestens zwei Kontakte aufweisen, welche Kontakte supraleitend verbunden sind, und wobei wenigstens drei dieser Zellen supraleitend und/oder nicht supraleitend elektrisch in Verbindung stehen. Der Kern der Erfindung liegt nun darin, dass die Kontakte der wenigstens drei Zellen derart bestrombar sind, dass jeweils über mindestens zwei Kontakte einer Zelle eine zeitveränderliche Spannung abfällt, deren zeitliches Mittel nicht verschwindet und dass die wenigstens drei Zellen auf eine Weise geometrisch unterschiedlich ausgestaltet sind, dass die bei einem vorhandenen magnetischen Feld von den Zellen eingeschlossenen magnetischen Flüsse sich derart unterscheiden, dass das Frequenzspektrum der Spannungsantwortfunktion in Bezug auf den magnetischen Fluss keinen signifikanten $\Phi_0$-periodischen Anteil besitzt oder dass, falls ein diskretes Frequenzspektrum existiert, der Beitrag des $\Phi_0$-periodischen Anteils des diskreten Frequenzspektrums im Vergleich zu dem nicht $\Phi_0$-periodischen Anteil des diskreten Frequenzspektrums nicht dominant ist.

Im Hinblick auf die Periodizität der Spannungsantwortfunktion kann auch der folgende funktionale Ansatz gewählt werden: Dass die wenigstens drei Zellen derart geometrisch unterschiedlich ausgestaltet sind, dass die bei einem vorhandenen magnetischen Feld von den Zellen eingeschlossenen magnetischen Flüsse derart in einem Verhältnis zueinander stehen, dass die Periode der Spannungsantwortfunktion des Netzwerks in Bezug auf den die Netzwerkzellen in ihrer Gesamtheit durchsetzenden magnetischen Fluss größer oder sehr viel größer als der Wert eines elementaren Flussquants ist bzw. die Spannungsantwort keinen $\Phi_0$-periodischen Anteil mehr aufweist. Der Erfindung liegt die Erkenntnis zugrunde, dass im Idealfall die Spannungsantwortfunktion keine Periode mehr besitzt, wenn die von den Zellen eingeschlossenen magnetischen Flüsse in keinem rationalen Verhältnis zueinander stehen. Vorzugsweise sind zusätzlich die Flächenunterschiede der einzelnen Zellen vergleichsweise groß. Insbesondere in diesem Fall superpositionieren supraleitend verbundene Zellen in einer Weise, dass die Spannungsantwortfunktion keine Periode mehr aufweist.

Somit werden erfindungsgemäß gezielt unterschiedliche Zellen miteinander verschaltet, was der Fachmann bei herkömmlichen SQUID-Anordnungen immer vermeiden möchte. Dies kommt beispielsweise in der Veröffentlichung von HANSEN, BINSLEV J., LINDELOF P.E.: Static and dynamic interactions between Josephson junctions. In: Reviews of Modern Physics, Vol. 56, No. 3, July 1984, S. 431 - 459; zum Ausdruck. In dieser Veröffentlichung wird auf S. 434, linke Spalte, letzter Absatz sowie folgend auf der rechten Spalte ein System mit identischen Zellen und identischen Kontakten favorisiert und dagegen Unsymmetrien als kontraproduktiv für die Funktion des diesbezüglich beschriebenen SQUIDs eingestuft.

Erfindungsgemäße Vorrichtungen (im Folgenden als supraleitende Quanten-Interferenz-Filter oder SQIF bezeichnet) zeigen den physikalischen Effekt der multiplen makroskopischen Quanten-Interferenz hingegen derart, dass die Mehrdeutigkeit der Eichkurven herkömmlicher SQUID-Magnetometer und -Gradiometer beseitigt wird.

In einem supraleitenden Quanten-Interferenz-Filter interferieren die quantenmechanischen Wellenfunktionen, welche den Zustand des supraleitenden Festkörpers beschreiben, derart, dass eine eindeutige makroskopische Eichkurve $\langle V(\vec{B};I_0)\rangle$ entsteht. Die Eichkurve $\langle V(\vec{B};I_0)\rangle$ des supraleitenden Quanten-Interferenz-Filters besitzt im Idealfall keine Periodizität mit der Periode $\Phi_0$ und ist eine in einem bestimmten Messbereich monoton steigende Funktion des Betrags des äußeren magnetischen Feldes $\vec{B}$ am Ort des SQIFs.

Die Eindeutigkeit der Eichkurve und die hohe Empfindlichkeit von supraleitenden Quanten-Interferenz-Filtern erlauben die direkte Messung zeitveränderlicher elektromagnetischer Felder in einem kontinuierlichen Frequenzbereich, dessen untere Schranke bei $\nu_{ext}\approx0$ und dessen obere Schranke je nach Art der verwendeten Josephson-Kontakte oder weak links zur Zeit bei mehreren hundert GHz bis THz liegt. Dieser gesamte Frequenzbereich ist mit einem einzigen entsprechend ausgelegten supraleitenden Quanten-Interferenz-Filter zugänglich. Bei der Detektion elektromagnetischer Wellen operiert der supraleitende Quanten-Interferenz-Filter simultan als Empfangsantenne, Filter und leistungsfähiger Verstärker. Das Eigenrauschen von geeignet ausgelegten Quanten-Interferenz-Filtern kann dabei um mehrere Größenordnungen kleiner sein als das Eigenrauschen konventioneller SQUID-Magnetometer. Ein weiterer Vorteil gegenüber herkömmlichen Antennen und Filtern liegt dabei unter anderem darin, dass bedingt durch das Messprinzip der Frequenzbereich nicht von der räumlichen Ausdehnung des supraleitenden Quanten-Interferenz-Filters abhängt. Die räumliche Ausdehnung kann lediglich die Empfindlichkeit beeinflussen.

Die Herstellung von supraleitenden Quanten-Interferenz-Filtern kann nach bekannten kostengünstigen technischen Verfahren erfolgen, wie sie etwa in der modernen Fertigung konventioneller SQUIDs angewandt werden. Da sich die räumliche Ausdehnung von supraleitenden Quanten-Interferenz-Filtern nicht wesentlich von der räumlichen Ausdehnung konventioneller SQUID-Systeme unterscheiden muss, können die für konventionelle SQUID-Systeme entwickelten Kryotechnologien direkt übernommen werden. Spezielle Entwicklungen auf dem Gebiet der Kryotechnologie sind nicht nötig.

Vorzugsweise sind in einem System aus oben beschriebenen Zellen zumindest für eine Zelle, günstigerweise für den größten Teil der Zellen genau zwei Kontakte pro Zelle vorgesehen, welche supraleitend verbunden und elektrisch parallel geschaltet sind. Durch genau zwei Kontakte lassen sich die soeben beschriebenen Effekte vergleichsweise einfach und gut erreichen.

Die gewünschten Effekte lassen sich jedoch auch in günstiger Weise erzielen, wenn in einer Zelle mehr als zwei Kontakte vorgesehen sind, die supraleitend verbunden und elektrisch parallel geschaltet sind, und zwar in Form einer Serienschaltung von Kontakten, die mit einem Einzelkontakt parallel geschaltet ist, oder in Form von zwei parallel geschalteten Serienschaltungen von Kontakten.

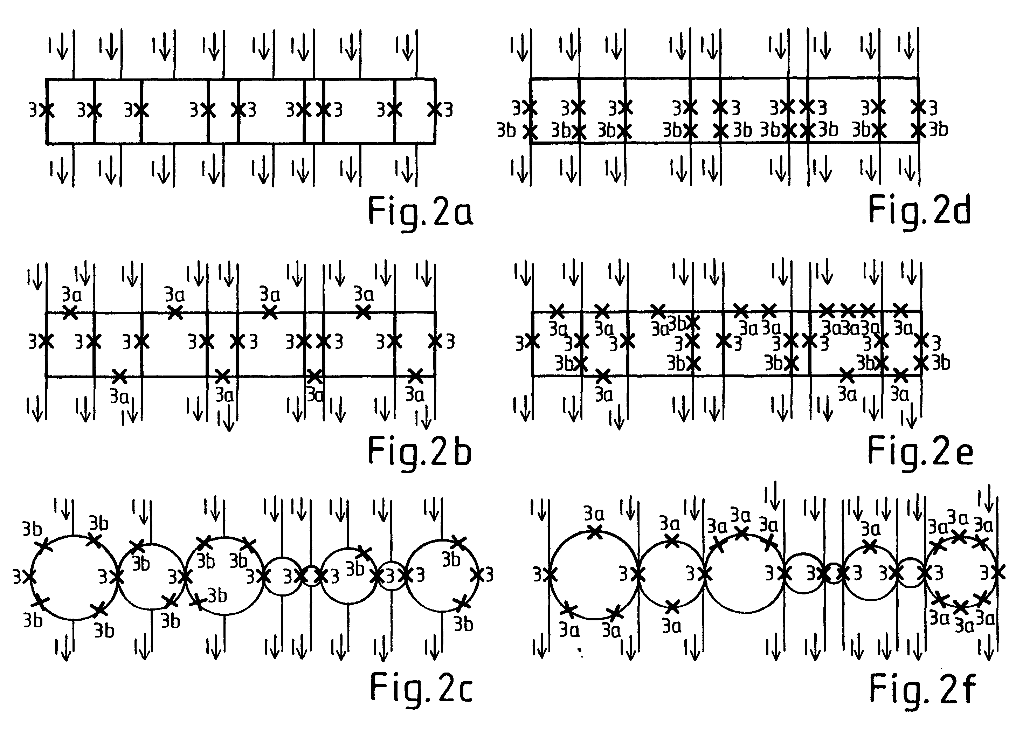

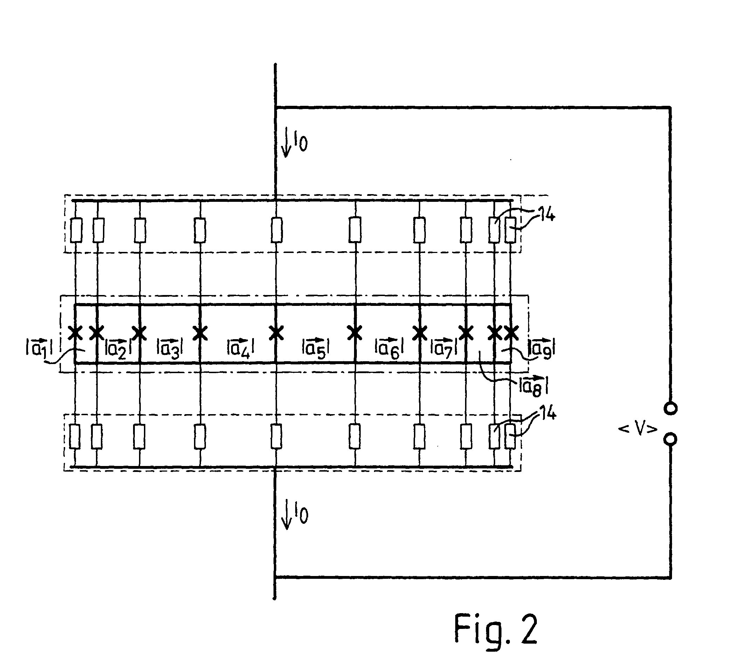

Die erfindungsgemäßen Effekte lassen sich jedoch auch durch Strukturen wenigstens einer Zelle eines Netzwerks erreichen, bei denen neben einer Grundform von mindestens zwei Kontakten, an welchen eine im zeitlichen Mittel nicht verschwindende, zeitveränderliche Spannung abfällt, insbesondere neben einer Grundform von zwei elektrisch parallel geschalteten Kontakten, ein weiterer Kontakt oder mehrere weitere Kontakte vorgesehen sind, welche Kontakte nicht direkt bestromt werden (vgl. Fig. 2b, 2e und 2f) und daher an diesen Kontakten im Mittel keine Spannung abfällt. Die Verbindungen aller Kontakte in den einzelnen Zellen ist dabei weiterhin supraleitend. Solche Ausführungsformen können von Vorteil sein, da durch zusätzliche Kontakte die von einem magnetischen Feld in den einzelnen Zellen induzierten Abschirmströme reduziert werden können. Der Einfluss von Eigen- und Gegeninduktivitäten kann dadurch vermindert werden.

Zum Stand der Technik können die folgenden Literaturstellen angegeben werden.

A. Barone and G. Paterno, Physics and Applications of the Josephson Effect, John Wiley, 1982.
J. Hinken, Superconducting Electronics, Springer, 1988.
K.K. Likharev, Dynamics of Josephson junctions and circuits. Gordon and Breach, New York,1991.
T.P. Orlando and K.A. Delin, Foundations of Applied Superconductivity. Addison-Wesley, 1991.
R.D. Parmentier and N.F. Pedersen, Nonlinear superconducting devices and high-Tc materials. World Scientific, 1995.
C.P. Poole, H.A. Farach, and R.J. Creswick, Superconductivity. Academic Press, 1995.
J.B. Ketterson and S.N. Song, Superconductivity. Cambridge University Press, 1995.
S.T Ruggiero and D.A. Rudman, Superconducting Devices. Academic Press, 1990.
J.C. Gallop u.a., SQUIDS, the Josephson Effekt and superconducting electronics. Hilger, 1991.
T. VanDuzer and C.W. Turner, Principles of Superconductive Devices and Circuits. Elsevier, 1981.
J. Oppenländer, W. Güttinger, T. Traeuble, M. Keck, T. Doderer, and R.P. Huebener, IEEE Trans. Supercon. 9, 4337 (1999).
J. Oppenländer, Ch. Häussler, and N. Schopohl, J. Appl. Phys. 86, 5775 (1999).
H. Weinstock (editor), SQUID Sensors: Fundamentals, Fabrication and Applications. Kluwer Academic Publishers, 1996.

In einer besonders bevorzugten Ausführungsform der Erfindung bilden mehrere Zellen ein Netzwerk oder einen Netzwerkabschnitt, in welchem alle Kontakte elektrisch parallel geschaltet sind, so dass die Kontakte gleich gerichtet bestrombar sind. Insbesonders, wenn in diesem Zusammenhang die Zellen supraleitend miteinander in Verbindung stehen, lassen sich durch eine derartige Anordnung besonders große Empfindlichkeiten für die Messung eines Magnetfeldes erzielen.

Mehrere Zellen oder Netzwerkabschnitte lassen sich vorteilhafterweise jedoch auch elektrisch in Reihe schalten, so dass wiederum die Kontakte im Netzwerk in der gleichen Richtung bestrombar sind. Durch diese Maßnahme kann die Größe des Messsignals erhöht werden, da sich in der Reihenschaltung die Spannungen an den Kontakten addieren. Eine besonders hohe Empfindlichkeit kann auch durch die Parallelschaltung von Serienanordnungen mehrerer Zellen oder Netzwerkabschnitte erreicht werden. Da wegen der größeren Zahl von Zellen in solchen Ausführungsformen das Eigenrauschen zudem stark abnimmt, ermöglicht dies auch die Detektion magnetischer Felder, deren Stärke um mehrere Größenordnungen kleiner ist als bei konventionellen SQUID-Systemen. Vorzugsweise sind in dieser Ausführungsform die Netzwerkabschnitte oder Zellen supraleitend verschaltet, insbesondere durch supraleitende twisted-pair-Kabel. Das Auflösungsvermögen von supraleitenden Quanten-Interferenz-Filtern kann dabei bis in den Bereich von aT ($10^{-18}$ Tesla) und darunter reichen. Die Eichkurve bleibt auch für solche Messbereiche eindeutig, so dass absolute quantitative Messungen von extrem kleinen Feldern möglich werden.

Das Netzwerk kann spannungsgetrieben oder stromgetrieben eingesetzt werden.

Um möglichst ideale Josephson-Effekte zu erzielen, wird überdies vorgeschlagen, dass die Kontakte als Punktkontakte ausgeführt sind.

Um die Empfindlichkeit einer erfindungsgemäßen Vorrichtung zu erhöhen, wird außerdem vorgeschlagen, dass die Geometrie der Zellenanordnung derart ausgeführt ist, dass ein magnetisches Übersprechen einer Zelle auf eine benachbarte Zelle aufgrund des durch einen in den Zellen fließenden Stroms hervorgerufenen magnetischen Eigenfeldes reduziert wird.

In einer weiteren vorteilhaften Ausgestaltung der Erfindung ist das Netzwerk mit einer das magnetische Feld verdrängenden und/oder verstärkenden supraleitenden Schlaufen- und/oder Flächenanordnung derart ausgestattet, dass der von einem primären magnetischen Feld in diesen supraleitenden Bereichen erzeugte magnetische Fluss in die Zellen des Netzwerks eingekoppelt wird. Bei SQUIDs ist dies eine bekannte Methode, deren Empfindlichkeit zu erhöhen, da solche Schlaufenanordnungen bedingt durch den sogenannten Meissner-Effekt des Supraleiters die Eigenschaft haben, den sie durchsetzenden magnetischen Fluss in ihre äußere Umgebung zu drängen. Wird in diese äußere Umgebung ein SQIF oder SQUID angeordnet, herrscht dann ein durch diesen pick-up-loop stark erhöhtes Magnetfeld. Dies gilt nicht nur für Schlaufenanordnungen, sondern auch für flächenhafte supraleitende Bereiche (sogenannte washer). Man spricht in diesem Zusammenhang auch von "Flussfokussierung". Es hat sich herausgestellt, dass ein SQIF sehr viel besser an einen sogenannten pick-up-loop angekoppelt werden kann als ein herkömmlicher SQUID. Denn bei herkömmlichen SQUIDs mit einem pick-up-loop besteht das Problem, dass wegen der sehr unterschiedlichen effektiven Fläche des SQUIDs (regelmäßig höchstens ca. 50 $\mu m$ x 50 $\mu m$) und der effektiven Fläche des pick-up-loops (regelmäßig in der Größenordnung cm x cm) eine sehr starke Impedanzfehlanpassung auftritt, die insbesondere bei HF-Frequenz-Anwendungen ein großes Problem darstellt. Da die effektive (Gesamt-)Fläche von SQIFs im Allgemeinen sehr viel größer ist als die von SQUIDs, ist das Problem einer Impedanzfehlanpassung bei SQIFs sehr viel kleiner bzw. gelöst.

In einer weiteren bevorzugten Ausgestaltung der Erfindung sind die Zellen des Netzwerkes und/oder Netzwerkabschnitte räumlich, insbesondere räumlich zwei- oder dreidimensional ausgerichtet. Durch diese Maßnahme wird es möglich, zusätzlich zum Betrag des Magnetfeldes einzelne Magnetfeldkomponenten zu bestimmen. Bei einer räumlich dreidimensionalen Anordnung lässt sich somit die Richtung des Magnetfelds messen.

Im Weiteren ist es bevorzugt, wenn der die Kontakte treibende Strom in das Netzwerk durch ohmsche Widerstände, welche insbesondere als bus-bar-Widerstände ausgeführt sind, eingespeist und/oder wieder abgeführt wird. Denn Messungen haben gezeigt, dass die Einspeisung des treibenden Stroms durch ohmsche Widerstände die Performance des SQIF erheblich verbessern kann.

In einer darüber hinaus bevorzugten Ausgestaltung der Erfindung sind einzelne Zellen und/oder Netzwerkabschnitte und/oder das gesamte Netzwerk mit einer Kompensationsschaltung zur Erzeugung eines sekundären magnetischen Feldes derart ausgestattet, dass der durch ein primäres magnetisches Feld erzeugte magnetische Fluss durch einzelne Zellen, Netzwerkabschnitte oder das gesamte Netzwerk kontrolliert kompensiert werden kann. Dies kann insbesondere dadurch realisiert werden, dass am Ort einzelner Zellen und/oder Netzwerkabschnitte und/oder des gesamten Netzwerks ein steuerbares statisches oder zeitveränderliches Magnetfeld erzeugt wird. Dadurch ist der Messbereich des supraleitenden Quanten-Interferenz-Filters im Prinzip beliebig wählbar.

Vorzugsweise steht die erfindungsgemäße Vorrichtung mit einem elektronischen Rechner in Verbindung, um beispielsweise die Spannungsantwort des Netzwerks auszuwerten oder die Kompensationsschaltung zu steuern.

Zeichnungen

Mehrere Ausführungsbeispiele der Erfindung sind in den Zeichnungen dargestellt und unter Angabe weiterer Vorteile und Einzelheiten näher erläutert.

Es zeigen

Fig. 1a und b ein mehrzelliges Netzwerk aus parallel geschalteten Josephsonkontakten in räumlicher Darstellung,

Fig. 2 das Schaltbild eines äquivalenten supraleitenden Stromkreises eines Quanten-Interferenz-Filters mit $N = 10$ Kontakten,

Fig. 2a bis f Schaltbilder von weiteren erfindungsgemäßen supraleitenden Stromkreisen,

Fig. 3 eine Spannungsantwortfunktion für ein Netzwerk mit $N = 30$ Kontakten,

Fig. 4a und b periodische Spannungsantwortfunktionen für herkömmliche SQUIDs,

Fig. 4c die Spannungsantwortfunktion eines erfindungsgemäßen supraleitenden Quanten-Interferenz-Filters,

Fig. 4d die Spannungsantwortfunktion eines SQUIDs und eines SQIFs,

Fig. 5 eine symbolisch dargestellte räumliche Anordnung eines supraleitenden Quanten-Interferenz-Filters mit angedeuteter vektorieller Basis des dreidimensionalen Raumes,

Fig. 6 ein schematisch dargestelltes, ebenes supraleitendes Quanten-Interferenz-Filter mit einer Magnetfeldkompensationseinrichtung,

Fig. 7 ein supraleitendes Quanten-Interferenz-Filter mit einer parallel geschalteten Steuerleitung in schematischer Ansicht,

Fig. 8 eine schematisch dargestellte Vernetzung von SQIF-Abschnitten,

Fig. 9a bis c schematisch dargestellte, ebene, supraleitende Quanten-Interferenz-Filter mit einer geometrischen Anordnung zur Minimierung des Einflusses von Eigenfeldern,

Fig. 10a ein Netzwerk aus in Serie geschalteten Netzwerkzellen,

Fig. 10b eine zu einem Netzwerk gemäß Fig. 10a entsprechende Spannungsantwortfunktion bei einer Serienschaltung für $N$ = 100 Netzwerkzellen,

Fig. 10c     eine Stromspannungskennlinie eines Netzwerks gemäß Fig. 10a, wenn es als Stromverstärker mit Hilfe eines Kompensationsstromkreises betrieben wird,

Fig. 11a     im oberen Bild die typische Spannungsantwortfunktion eines herkömmlichen SQUIDs mit dem zugehörigen Frequenzspektrum im unteren Bild,

Fig. 11b     im oberen Bild eine typische Spannungsantwortfunktion eines Netzwerks aus identischen Zellen und das zugehörige Frequenzspektrum im unteren Bild,

Fig. 11c     im oberen Bild die Spannungsantwortfunktion eines erfindungsgemäßen Interferenz-Filters ohne Periodizität und das dazugehörige Spektrum im unteren Bild,

Fig. 11d     im oberen Bild eine Spannungsantwortfunktion und im unteren Bild das zugehörige Spektrum eines Quanten-Interferenz-Filters, welcher eine technisch bedingte, vergleichsweise große Periodizität besitzt

Fig. 12     die Eichkurve eines dc-SQUIDs und

Fig. 13     ein schematisch dargestelltes, ebenes supraleitendes Quanten-Interferenz-Filter mit einer das primäre magnetische Feld am Ort des Filters verstärkenden supraleitenden Einkoppelschlaufe (pick-up-loop).

## Beschreibung der Ausführungsbeispiele

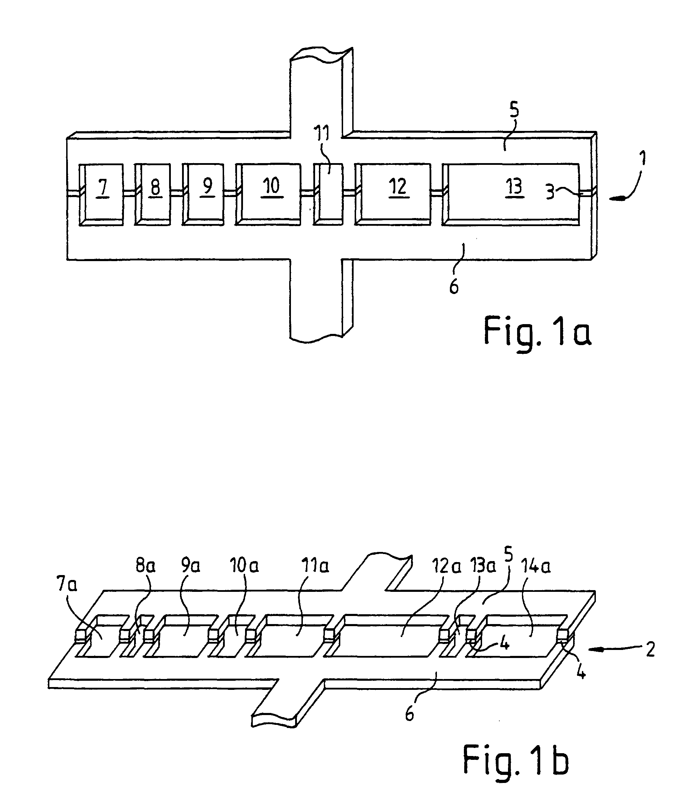

Die in Fig. 1 skizzierten Ausführungsbeispiele der Erfindung werden im Folgenden näher erläutert. Die Abbildungen gemäß Fig. 1a und 1b zeigen die erfindungsgemäßen physikalischen Realisierungen von einfachen Mehrschlaufen-Netzwerken 1, 2 mit Josephsonkontakten 3, 4, deren Geometrie und Detektionsverhalten supraleitende Quanten-Interferenz-Filter konstituieren. Die Netzwerke 1, 2 bestehen aus supraleitenden Bereichen 5, 6, die durch die Josephsonkontakte 3, 4 miteinander verbunden sind. Die supraleitenden Bereiche können dabei sowohl aus tieftemperatur-supraleitenden Materialen als auch aus hochtemperatur-supraleitenden Materialien bestehen. Auch von der speziellen Ausführung der Josephsonkontakte (z.B. break-junctions, step-junctions, Mikrobrücken etc.) hängt die erfindungsgemäße Funktionsfähigkeit des Netzwerks nicht ab. Die quantitativen Angaben zu den Ausführungsbeispielen beziehen sich beispielhaft auf die Parameterspezifikationen der dem Stand der Technik entsprechenden typischen Josephsonkontakte aus konventionellen Supraleitern, zum Beispiel solche mit der $Nb/Al0_X/Nb$-Technologie hergestellten Josephsonkontakten, wie sie in herkömmlichen SQUID-Magnetometer zum Einsatz kommen. Solche Kontakte besitzen typische kritische Ströme $i_c$ von etwa 200 μ$A$ und einen Normalwiderstand $r_n$, der durch einen extern parallelgeschalteten Ohmschen Widerstand definiert ist von z.B. etwa 1Ω, sowie eine geometrische shunt-Kapazität $c_n$ im Bereich von Pikofarad. Die räumliche Ausdehnung des Netzwerks kann vergleichbar mit der herkömmlicher SQUIDs sein. Die Abmessungen der Zellen der Netzwerke liegen dann im Bereich von μm bis mm. Erfindungsgemäße Netzwerke können je nach Anwendung aber auch Zellen mit größeren oder kleineren Abmessungen aufweisen.

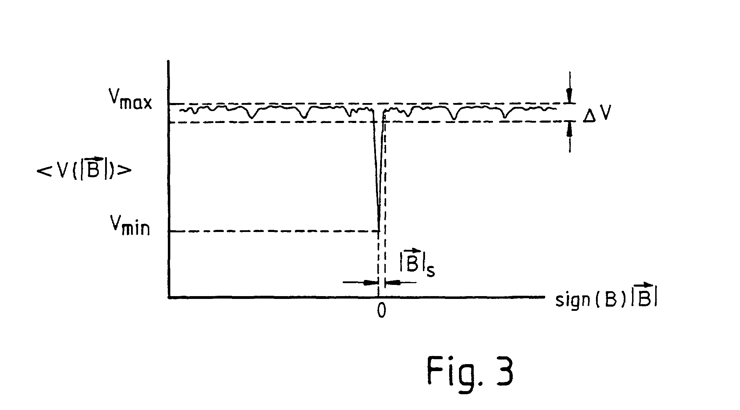

In den Fig. 1a und 1b wird der supraleitende Quanten-Interferenz-Filter konstituiert durch ein ebenes Netzwerk 1, 2 aus den Josephsonkontakten 3, 4, das Zellen 7 bis 13 bzw. 7a bis 14a besitzt, welche jeweils zwei Kontakte in Stromrichtung besitzen. Das Schaltbild des äquivalenten supraleitenden Stromkreises eines SQIFs mit $N$=10 Kontakten ist in Fig. 2 dargestellt. Das Netzwerk ist dadurch gekennzeichnet, dass die einzelnen Flächen der Zellen 7 bis 13 eine unterschiedliche Größe besitzen und die Flächeninhalte $|a_j|$ der verschiedenen Netzwerkzellen in keinem rationalen Verhältnis zueinander stehen. Mit 14 sind Ersatzwiderstände bezeichnet. Das Kreuz kennzeichnet die Josephsonkontakten 1 bis 10. Durch den strichpunktierten Kasten um die Josephsonkontakte wird der supraleitend verbundene Bereich verdeutlicht. Die fett durchgezogenen Linien innerhalb dieses Kastens symbolisieren supraleitende Verbindungen. Insbesondere unter diesen Voraussetzungen entsteht der physikalische Effekt der multiplen makroskopischen Quanten-Interferenz derart, dass die quantenmechanischen Wellenfunktionen, welche den Zustand der einzelnen supraleitenden Bereiche des Netzwerks beschreiben, nur dann konstruktiv interferieren, wenn der das Netzwerk durchsetzende magnetische Fluss identisch verschwindet. Der makroskopische Gesamtzustand des Netzwerks kann dadurch ausgelesen werden, dass das Netzwerk durch einen konstanten überkritischen Strom $I_0$ getrieben wird. Dann ergibt sich eine Spannungsantwortfunktion $\langle V(\vec{B};I_0)\rangle$, die nur ein globales absolutes Minimum bei $|\vec{B}|=0$ besitzt und bei anwachsendem $|\vec{B}|$ monoton ansteigt, bis schließlich ein annähernd konstant bleibender Wert $V_{max}(\vec{B};I_0)$ erreicht wird, der sich bei weiter anwachsendem $|\vec{B}|$ nicht mehr wesentlich ändert, wie dies in Fig. 3 für ein erfindungsgemäßes Netzwerk mit $N$=30 Kontakten schematisch dargestellt ist. Für ein am Ort des Netzwerks vorhandenes magnetisches Feld $\vec{B}$ mit $0<|\vec{B}|<|\vec{B}|_s$ ist die Spannungsantwortfunktion des supraleitenden Quanten-Interferenz-Filters daher eindeutig. Für $|\vec{B}|>|\vec{B}|_s$ ergibt sich eine nahe bei $V_{max}$ schwankende Spannungsantwort, deren Varianz mit anwachsendem $N$ schnell kleiner wird, wobei $V_{max}$ das globale absolute Maximum der Spannungsantwortfunktion ist (vgl. Fig. 3). Der Messbereich des supraleitenden Quanten-Interferenz-Filters wird bestimmt durch den Abstand zwischen dem globalen Minimum $V_{min}=\langle V(|\vec{B}|=0;I_0)\rangle$ und $V_{max}-\Delta V$, wobei $\Delta V$ den Abstand zwischen dem kleinsten lokalen Minimum für $|\vec{B}|>|\vec{B}|_s$ und $V_{max}$ bezeichnet. Der Wert $|\vec{B}|=0$ definiert damit die untere Grenze des Messbereichs und der Wert von $|\vec{B}|$, an dem die Spannungsantwort den Wert $V_{max}-\Delta V$ erreicht, definiert die obere Grenze $|\vec{B}|_s$ des Messbereichs (vgl. Fig. 3). Die Größe von $\Delta V$ hängt dabei von der Zahl der Zellen, welche das Netzwerk besitzt, und von der Wahl der Flächeninhalte der einzelnen Netzwerkzellen, bzw. von deren Verhältnissen zueinander ab. Dies wird in der im nächsten Absatz folgenden theoretischen Beschreibung des supraleitenden Quanten-Interferenz-Filters näher erläutert.

In den Fig. 2b bis f sind Ausführungsformen von Netzwerken skizziert, bei welchen die einzelnen Netzwerkzellen zusätzlich zu den zwei funktional notwendigen Kontakten 3 gemäß Fig. 2a einen weiteren Kontakt oder mehrere weitere Kontakte umfassen. Die Kontakte sind dabei als Kreuze gekennzeichnet. Die dick durchgezogenen Linien kennzeichnen supraleitende Verbindungen. Die dünn durchgezogenen Linien können normalleitend oder supraleitend sein. Die zusätzlichen Kontakte können dabei derart in den einzelnen Netzwerkzellen angebracht werden, dass durch sie kein oder nur ein geringer Teil des treibenden Stroms fließt (nicht direkt bestromte Kontakte 3a) und im Mittel auch keine zeitveränderliche Spannung abfällt. Durch solche Ausführungsformen können die von einem magnetischen Feld in den einzelnen Zellen induzierten Abschirmströme reduziert werden. Des Weiteren kann daher der Einfluss von Eigen- und Gegeninduktivitäten dadurch vermindert werden. Die zusätzlichen Kontakte können jedoch auch so angebracht sein, dass sie vom treibenden Strom I durchflossen werden (direkt bestromte Kontakte 3b). Auch eine Kombination von einem Kontakt 3a oder mehreren Kontakten 3a und einem Kontakt 3b oder mehreren Kontakten 3b in einzelnen oder mehreren Zellen des Netzwerks ist möglich.

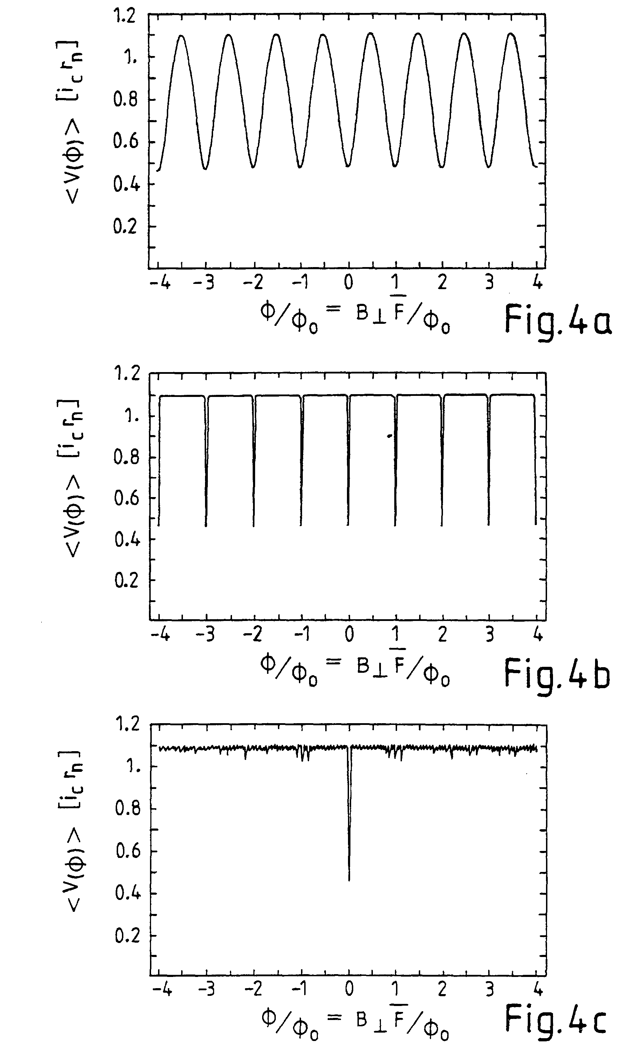

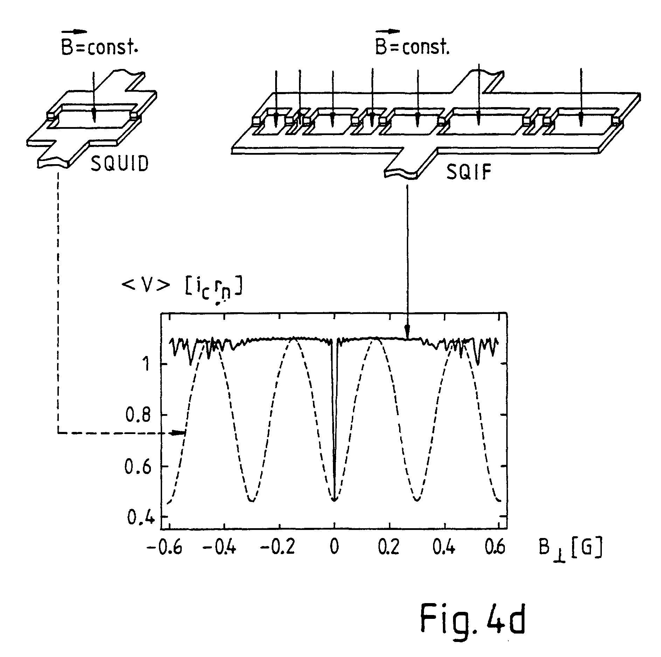

In den Fig. 4a bis 4c ist zum direkten Vergleich die Spannungsantwortfunktion eines konventionellen Einschlaufen-SQUIDs (Fig. 4a), eines konventionellen Mehrschlaufen-SQUIDs mit regelmäßigen Einheitszellen identischer Größe (Fig. 4b) und eines supraleitenden Quanten-Interferenz-Filters (Fig. 4c) dargestellt. Besagtes Beispiel zum Einschlaufen-SQUID besteht aus einer einzelnen supraleitenden Schlaufe bzw. Zelle mit zwei Josephsonkontakten, der Mehrschlaufen-SQUID aus einer Parallelanordnung solcher identischer Einschlaufen-SQUIDs ("Leiterarray") mit $N$=30 Kontakten, und der supraleitende Quanten-Interferenz-Filter ist erfindungsgemäß aufgebaut und besitzt ebenfalls $N$=30 Kontakte. Der treibende Strom $I_0$ ist für alle drei Anordnungen so gewählt, dass für $|\vec{B}|=0$ der Strom pro Kontakt den Wert $1.1\, i_c$ besitzt, so dass der Spannungshub $V_{max}-V_{min}$ für alle drei Vorrichtungen gleich ist. In Fig. 4d sind die Spannungsantwortfunktionen eines konventionellen SQUIDs und eines SQIFS noch einmal anhand eines konkreten Ausführungsbeispiels dargestellt. Während Vorrichtungen gemäß dem Stand der Technik (Einschlaufen-SQUID und Mehrschlaufen-SQUID) eine periodische Spannungsantwortfunktion $\langle V \rangle$ mit der Periode $\Phi_0$ derart besitzen, dass keine absolute Messung des magnetischen Feldes möglich ist, besitzt der ebene supraleitende Quanten-Interferenz-Filter eine eindeutige Spannungsantwortfunktion. Diese Spannungsantwortfunktion des SQIFs ermöglicht dadurch die absolute quantitative Messung des magnetischen Feldes. Im gewählten Beispiel liegt der Messbereich zwischen $\Phi=0$ und $\Phi\equiv B_\perp \bar{F}\approx 0.02\Phi_0$. Bei einer mittleren Netzwerkzellenfläche $\bar{F}$ im Bereich von $\mu m^2$ entspricht dies Magnetfeldstärken zwischen $B_\perp=0$ und $B_\perp=10^{-4}$ T und für $\bar{F}$ im Bereich von $mm^2$ Magnetfeldstärken zwischen $B_\perp=0$ T und $B_\perp=10^{-10}$ T. Die Auflösungsgrenze kann bei diesen Beispielen im Bereich von $10^{-13}$ T bis $10^{-16}$ T liegen.

Durch Verwendung einer Kompensationsschaltung, mit deren Hilfe ein magnetischer Fluss bekannter Stärke kontrolliert in den supraleitenden Quanten-Interferenz-Filter eingekoppelt werden kann, lässt sich der Messbereich der erfindungsgemäßen Vorrichtung bei gleichbleibender Empfindlichkeit beliebig variieren. Entsprechende Vorrichtungen werden in den weiteren Ausführungsbeispielen vorgestellt.

Die elektrotechnische theoretische Beschreibung des supraleitenden Quanten-Interferenz-Filters kann mit Hilfe des sogenannten RCSJ -Modells (RCSJ = resistively and capacitively shunted junction) für die einzelnen Josephsonkontakte unter Berücksichtigung der Netzwerktheorie für supraleitende Schaltungen erfolgen. Im RCSJ-Modell wird der einzelne Josephsonkontakt durch eine nichtlineare Induktivität beschrieben, der ein ohmscher shunt-Widerstand $r_n$ und eine geometrische, die Tunnelbarriere charakterisierende shunt-Kapazität $c_n$ parallelgeschaltet sind. Die Beschreibung des makroskopischen Zustands der Josephsonkontakte erfolgt durch die eichinvariante Differenz der makroskopischen quantenmechanischen Phasen an den beiden gegenüberliegenden supraleitenden Elektroden des jeweiligen Kontakts. Diese Phasendifferenz wird mit $\phi_j$ bezeichnet, wobei $j$=1...$N$ die einzelnen Kontakte des Netzwerks indiziert. Die der Netzwerkdynamik zugrundeliegenden Relationen sind dann durch

$$I_j = i_c\,\sin(\phi_j)+\frac{v_j(t)}{r_n}+ c_n\,\partial_t v_j(t), \qquad\qquad (1)$$

$$v_j(t) = \frac{\hbar}{2e}\partial_t \phi_j, \qquad\qquad (2)$$

$$\phi_{j+1} - \phi_j = 2\pi\frac{\Phi_j}{\Phi_0} \qquad\qquad (3)$$

gegeben, wobei $I_j$ den durch den Kontakt mit Index $j$ fließenden Strom mit $\Sigma_{j=1}^{N} I_j = I_0$ und $\Phi_j$ den die Netzwerkzelle mit Index j durchsetzenden magnetischen Fluss bezeichnet. Gleichung 1 beschreibt die nichtlineare Relation zwischen dem Strom $I_j$ und der über dem Kontakt abfallenden Spannung $v_j(t)$ im RCSJ Modell. Gleichung 2 entspricht der zweiten Josephson-Relation, nach der die über dem Kontakt abfallende Spannung $v_j(t)$ direkt proportional der zeitlichen Ableitung $\partial_t\phi_j$ der Phasendifferenz $\phi_j$ ist. Gleichung 3 ist Ausdruck der Quantisierung des magnetischen Flusses durch eine geschlossene supraleitende Schlaufe.

Der Einfachheit halber wird bei der theoretischen Beschreibung angenommen, dass die Netzwerkkontakte identisch sind, d.h. dass sowohl die kritischen Ströme $i_c$ als auch die parallelgeschalteten shunt-Widerstände $r_n$ und shunt-Kapazitäten $c_n$ nicht statistisch oder systematisch streuen. Das Auftreten von typischen fertigungsbedingten Parameterstreuungen beeinträchtigt die Funktionsfähigkeit des supraleitenden Quanten-Interferenz-Filters jedoch nicht. Die theoretische Beschreibung im Rahmen des RCSJ-Modells beschränkt sich zudem auf sogenannte Punktkontakte, d.h. auf Kontakte, die so klein sind, dass die Phasendifferenzen über die Ausdehnung der Kontaktbarriere nicht variieren. Dies ist eine auch bei der theoretischen Beschreibung konventioneller SQUIDs übliche Annahme. Bei supraleitenden Quanten-Interferenz-Filtern ist diese Annahme in besonderer Weise gerechtfertigt, da im Gegensatz zu konventionellen SQUIDs die auftretenden Interferenzmuster mit wachsender Zahl der Netzwerkzellen von der Netzwerkdynamik dominiert werden und daher nur äußerst schwach von der speziellen Geometrie der einzelnen Kontakte abhängen.

Die aus der Stromerhaltung und den Gleichungen 1 bis 3 folgenden Netzwerkgleichungen verknüpfen das am Ort des Netzwerks wirkende Magnetfeld $\vec{B}$ und den treibenden Strom $I_0$ mit der über der Schaltung abfallenden Spannung $V(t)$. Für statische oder im Vergleich zur Netzwerkfrequenz langsam variierende Magnetfelder $\vec{B}$ kann die Netzwerkgleichung für den SQIF dieses Ausführungsbeispiels und allgemein für SQIFs, die aus parallel geschalteten Netzwerkzellen bestehen, als nichtlineare Differentialgleichung der Form

$$\frac{\hbar}{2e}\frac{c_n}{i_c}\partial_t^2 \phi_1 + \frac{\hbar}{2e\,i_c\,r_n}\partial_t \phi_1 + \left|S_N(\vec{B})\right|\sin(\phi_1 + \delta_N) = \frac{I_0}{N\,i_c} \qquad\qquad (4)$$

$$v_1(t) = \frac{\hbar}{2e}\partial_t \phi_1 \qquad\qquad (5)$$

geschrieben werden, wobei sich das Magnetfeld $\vec{B} = \vec{B}_{ext} + \vec{B}_c$ aus dem zu messenden, primärem äußeren Feld $\vec{B}_{ext}$ und eventuell einem kontrolliert erzeugten, sekundären magnetischen Kompensationsfeld $\vec{B}_c$ zusammensetzt. Der in Gleichung 4 auftretende komplexe ($i=\sqrt{-1}$) Strukturfaktor

$$S_N(\vec{B}) = \left|S_N(\vec{B})\right|\exp\left[i\,\delta_N(\vec{B})\right]$$

beschreibt die geometrischen und dynamischen Eigenschaften des aus $N-1$ Zellen zusammengesetzten supraleitenden Quanten-Interferenz-Filters. Er bestimmt die räumlichen und zeitlichen Interferenzeigenschaften des Netzwerks in Abhängigkeit von der Stärke des zu messenden Magnetfelds. Die Phasenverschiebung $\delta_N$ hängt ebenfalls von der speziellen Geometrie der Anordnung ab, hat jedoch keinen Einfluss auf die zeitlich gemittelte Spannungsantwortfunktion $\langle V(\vec{B};I_0)\rangle$.

Der komplexe Strukturfaktor $S_N(\vec{B})$ ist zu

$$S_N(B) = \frac{1}{N} \sum_{n=0}^{N-1} \exp\left(\frac{2\pi i}{\Phi_0} \sum_{m=0}^{n} \langle \vec{B}, \vec{a}_m \rangle\right) \qquad (6)$$

definiert, wobei die Vektoren $\vec{a}_m$ die orientierten Flächenelemente ($\frac{\vec{a}_m}{|\vec{a}_m|}$ = Flächennormale, $|\vec{a}_m|$ = Flächeninhalt der m-ten Schlaufe) der einzelnen Netzwerkschlaufen bezeichnen und $\vec{a}_0 = 0$ gilt. Für den die einzelnen Netzwerkschlaufen durchsetzenden magnetischen Fluss gilt damit $\Phi_m = \langle \vec{B}, \vec{a}_m \rangle$, wobei für zwei beliebige Vektoren $\vec{a}, \vec{b}$ das Skalarprodukt durch $\langle \vec{a}, \vec{b} \rangle = |\vec{a}||\vec{b}|\cos\angle(\vec{a}, \vec{b})$ definiert ist. Variiert das Magnetfeld $\vec{B}$ über die Ausdehnung der Schlaufe, dann tritt an die Stelle dieses Skalarprodukts die entsprechende Integraldarstellung. Die Periodizität des Netzwerks wird durch die akkumulierten magnetischen Flüsse

$$\alpha_n = \sum_{m=0}^{n} \langle \vec{B}, \vec{a}_m \rangle \qquad (7)$$

mit $n = 0...N$-1 bestimmt.

Für konventionelle Einschlaufen-SQUIDs, bei denen nur eine orientierte Fläche $\vec{a}_1$ existiert, nimmt $S_N$ mit $N$=2 den Wert

$$S_2 = \tfrac{1}{2}\left(1 + \exp\left[\frac{2\pi i}{\Phi_0}\Phi\right]\right)$$

und

$$|S_2| = \cos\left(\frac{\pi\Phi}{\Phi_0}\right)$$

an. Für ebene periodische Mehrschlaufen-SQUIDs mit identischen Schlaufenflächen $\vec{a}_1 = \vec{a}_2 = \vec{a}_3 = ... = \vec{a}_{N-1}$ ist $\alpha_n = n\Phi$ mit $\Phi = B_\perp|\vec{a}_1|$, so dass

$$S_N = \tfrac{1}{N} \sum_{n=0}^{N-1} \exp\left[\frac{2\pi i}{\Phi_0} n\Phi\right]$$

eine geometrische Reihe ist, mit dem Ergebnis $|S_N| = \frac{\sin(N\pi\Phi/\Phi_0)}{N\sin(\pi\Phi/\Phi_0)}$. Die Strukturfaktoren für solche dem derzeitigen Stand der Technik entsprechenden konventionellen SQUIDs besitzen somit unabhängig von der Zahl der Kontakte periodische Strukturfaktoren. Diese periodischen Strukturfaktoren sind die Ursache für die ebenfalls streng $\Phi_0$-periodischen Spannungsantwortfunktionen $\langle V(\vec{B};I_0) \rangle$ solcher Vorrichtungen, und damit die Ursache dafür, dass mit solchen dem Stand der Technik entsprechenden Vorrichtungen eine absolute Messung des magnetischen Feldes nicht möglich ist. Erfindungsgemäße supraleitende Quanten-Interferenz-Filter besitzen demgegenüber keine periodischen Strukturfaktoren, da $S_N(\vec{B})$ nach Gleichung 6 für inkommensurable akkumulierte magnetische Flüsse $\alpha_n$ keine Periodizität aufweisen kann. Supraleitende Quanten-Interferenz-Filter besitzen damit auch keine periodischen Spannungsantwortfunktionen $\langle V(\vec{B};I_0) \rangle$ und ermöglichen dadurch die absolute Messung magnetischer Felder.

Nach Gleichung 3 gilt für statische oder im Vergleich zur Netzwerkfrequenz langsam variierende äußere Felder $v_j(t) = v_1(t)$ für alle j = 1 ... N, d.h. $v_1(t)$ definiert die über den supraleitenden Quanten-Interferenz-Filter abfallende Wechselspannung. Die Netzwerkfrequenz $\nu$ hängt über die Einstein-Relation $h\nu = 2e\langle V(\vec{B};I_0) \rangle$ mit dem zeitlichen Mittelwert dieser Wechselspannung, der Spannungsantwortfunktion $\langle V(\vec{B};I_0) \rangle = \frac{1}{T}\int_0^T v_1(t)dt$ zusammen, wobei $T = \frac{1}{\nu}$ gilt. Für typische $Nb/AlO_x/Nb$-Josephsonkontakte liegt die Netzwerkfrequenz $\nu$ bei etwa 100 GHz, so dass die Frequenz $\nu_{ext}$ des äußeren Feldes in einem Bereich zwischen $\nu_{ext}$=0 bis etwa 20 GHz liegen kann. Als einfach zugängliche Messgröße kann wie bei konventionellen SQUIDs die im zeitlichen Mittel über das Netzwerk abfallende Gleichspannung $\langle V(\vec{B};I_0) \rangle$ dienen. Der Einfluss von Induktivitäten und durch den Treiberstrom verursachten Eigenfelder wird in Gleichung 4 und 5 der besseren Verständlichkeit halber vernachlässigt. Tatsächlich können Induktivitäten und Eigenfelder bei geeigneter Auslegung des supraleitenden Quanten-Interferenz-Filters so minimiert werden, dass die Funktionsfähigkeit der Vorrichtung durch diese Einflüsse nicht beeinträchtigt wird. Entsprechende Vorrichtungen werden in den weiteren Ausführungsbeispielen vorgestellt.

Die Vernachlässigung der shunt-Kapazitäten $c_n$, die für typische Josephson-Kontakte in sehr guter Näherung gerechtfertigt ist, ermöglicht eine analytische Lösung für die Spannungsantwortfunktion:

$$\langle V(B;I_0)\rangle = i_c\, r_n \sqrt{\left(\frac{I_0}{N\,i_c}\right)^2 - |S_N(B)|^2} \tag{8}$$

Für alle dem derzeitigen Stand der Technik entsprechenden SQUIDs ist diese Spannungsantwortfunktion periodisch mit Periode $\Phi_0$, wie dies in Fig. 4a skizziert ist. Für erfindungsgemäße SQIFs hingegen ist die Spannungsantwortfunktion nicht periodisch. Dies ist in Fig. 4c dargestellt. Die Spannungsantwortfunktion des supraleitenden Quanten-Interferenz-Filters besitzt wie die Spannungsantwortfunktion konventioneller SQUIDs ein Minimum für $\Phi=0$. Im Gegensatz zu konventionellen SQUIDs wiederholt sich dieses Minimum bei anwachsendem äußerem Feld jedoch nicht. Damit ist die Spannungsantwort für $\Phi=0$ eindeutig ausgezeichnet und ermöglicht je nach Auslegung direkt oder mit Hilfe einer geeigneten Kompensationsschaltung für das magnetische Feld die absolute quantitative Messung des äußeren magnetischen Feldes. Da der Betrag des Strukturfaktors $S_N$ in Gl. 8 quadratisch eingeht, schwankt die Spannungsantwortfunktion für erfindungsgemäße Vorrichtungen auf dem oberen Teil des Graphen nur sehr leicht um den Wert $V_{max}$ und es ergibt sich eine ausgeprägt steile Flanke zwischen $V_{min}$ und $V_{max}$ (vgl. Fig. 4c) .

Der Strukturfaktor $S_N(\vec{B})$ des supraleitenden Quanten-Interferenz-Filters kann derart optimiert werden, dass die Spannungsantwortfunktion $\langle V(\vec{B};I_0)\rangle$ einen maximalen Messbereich $0<|\vec{B}|<|\vec{B}|_s$ besitzt. Dies ist dann der Fall, wenn der Abstand $\Delta V$ zwischen dem kleinsten lokalen Minimum von $V$ und dem maximalen Spannungswert $V_{max}$ für gegebene Gesamtfläche $\sum_{m=1}^{N-1}|\vec{a}_m|$ (vgl. auch Fig. 3) und gegebene Zahl der Netzwerkkontakte $N$ im Operationsbereich minimal wird. Der maximale Operationsbereich eines supraleitenden Netzwerkes ist dabei durch die maximal erreichbare Kompensationsfeldstärke bestimmt.

Für ebene Netzwerke kann der Fall eintreten, dass eine durch den Fertigungsprozess verursachte minimal mögliche Längenvariation $l_0$ der Leiterbahnen auftritt. Die Flächeninhalte $|\vec{a}_m|$ der Netzwerkschlaufen können dann durch $|\vec{a}_m| = q_m l_0^2$ definiert werden, wobei die Zahlen $q_m$ positive ganze Zahlen sind. Im ungünstigsten Fall dürfen sich damit zwei Flächenelemente fertigungsbedingt nur um den Betrag von $l_0^2$ unterscheiden. Dies führt dazu, dass der Strukturfaktor $S_N(\vec{B})$ und damit die Spannungsantwortfunktion $\langle V(\vec{B};I_0)\rangle$ des supraleitenden Quanten-Interferenz-Filters rein theoretisch betrachtet periodisch variieren könnte. Die möglicherweise auftretende Periode ist allerdings in Bezug auf $\Phi_0$ sehr groß und entspricht $\frac{\Phi_0}{GGT}A_{tot}$, wenn GGT der größte gemeinsame Teiler der Beträge $|\vec{a}_m|$ der orientierten Flächenelemente eines planaren Netzwerks ist und $A_{tot}$ die Gesamtfläche des SQIF, $A_{tot} = \sum_{m=1}^{N-1}|\vec{a}_m|$ bezeichnet. Ein typischer, dem Stand der Technik entsprechender Wert für $l_0$ beträgt etwa hundert nm (Niob-Prozess). Die minimale Flächendifferenz $l_0^2$ liegt damit in der Größenordnung von $10^{-2}\,\mu m^2$ bei einer angenommenen Netzwerkzellenfläche des supraleitender Quanten-Interferenz-Filters von $10^{-2}mm^2$. Sind die Zahlen $q_m$ nun selbst teilerfremd, etwa dadurch, dass sie zu (verschiedenen) Primzahlen gewählt werden, dann ist die Periode der Spannungsantwortfunktion zu $\frac{\Phi_0}{l_0^2}A_{tot}$ gegeben. Diese Periode liegt für typische Gesamtflächen $A_{tot}$ von mehreren 1000 $\mu m^2$ weit außerhalb des praktisch relevanten Mess- oder Operationsbereichs. Für einen in einer bestimmten Anwendung gegebenen Operationsbereich existiert damit immer ein supraleitender Quanten-Interferenz-Filter mit optimaler Fläche, Kontaktanzahl und zugehörigem Strukturfaktor.

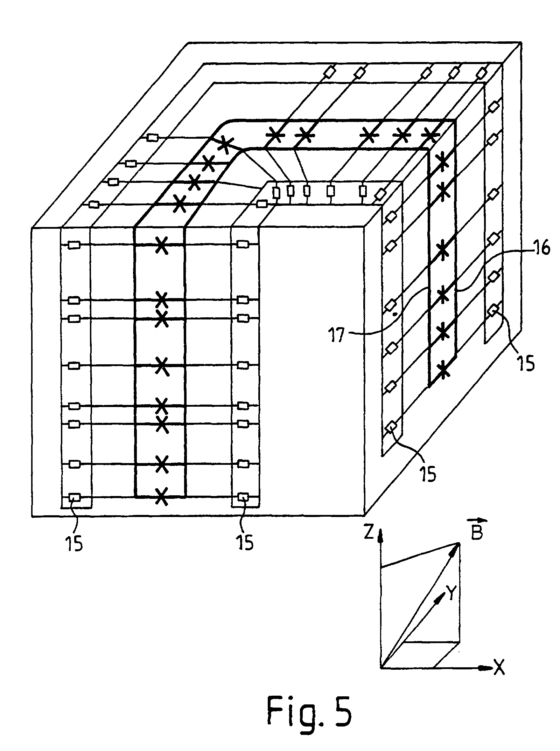

Ein weiteres Ausführungsbeispiel der Erfindung ist in Fig. 5 dargestellt. Die Netzwerkzellen zerfallen hier in drei Gruppen derart, dass aus den orientierten Flächenelementen $\vec{a}_m$ eine vollständige vektorielle Basis des dreidimensionalen Raumes gebildet werden kann. Diese Ausführung der Erfindung, die im Folgenden als Vektor-SQIF bezeichnet wird, hat den Vorteil, dass durch entsprechend ausgelegte Kompensationsfelder, die zum Beispiel jeweils ein kontrollierbares sekundäres Feld parallel zu jedem der aus den $\vec{a}_m$ gebildeten Basisvektoren erzeugen, sowohl die Stärke als auch die Richtung des zu messenden primären magnetischen Feldes eindeutig und mit sehr hoher Genauigkeit bestimmt werden kann. Dies ermöglicht die eindeutige quantitative Rekonstruktion des primären Magnetfeldvektors $\vec{B}_{ext}$ nach Betrag, Richtung und Phase, und erlaubt eine Vielzahl neuartiger Anwendungen. Schon mit zwei solcher erfindungsgemäßen Anordnungen ist es z.B. möglich, die Quellen eines magnetischen Feldes exakt zu lokalisieren und ihre Stärke zu bestimmen. Hierzu kann das drahtlose Auslesen von Detektorfeldern gehören, wenn die einzelnen Detektorsignale aus temporären elektrischen Strömen bestehen. Auch das Auslesen oder die Verarbeitung von elektronischen oder magnetischen Datenspeichern ist durch solche Anordnungen berührungslos und praktisch ohne Leistungsaufnahme oder - abgabe durch den SQIF bei einer sehr hohen zeitlichen Auflösung und damit einer extrem schnellen Verarbeitungsgeschwindigkeit im GHz bis THz Bereich möglich. Weitere Beispiele für die Anwendung solcher Vektor-SQIFs sind die räumlich und zeitlich hochaufgelöste Messung von Stoffwechselvorgängen, etwa im menschlichen Gehirn, von Signalen der Kernspin-Resonanz oder der Magnetfeldverteilung in der oberen Erdkruste, wie etwa in der Geoexploration. In Fig. 5 sind durch die Kreuze die Josephsonkontakte symbolisiert, mit dem Bezugszeichen 15 sind bus-bar-Widerstände bezeichnet. Die dicken durchgezogenen Linien stellen supraleitende Verbindungen dar. Die beiden dicken durchgezogenen Linien 16, 17 begrenzen zudem den supraleitend verbundenen Teil des Netzwerks.

In einem nicht dargestellten Ausführungsbeispiel ist der Vektor-SQIF aus drei unabhängig voneinander operierenden einzelnen ebenen SQIFs, deren Flächennormalen eine vektorielle Basis des dreidimensionalen Raumes bilden, aufgebaut. Diese Vorrichtung hat den Vorteil, dass die einzelnen ebenen SQIFs mit den dem derzeitigen Stand der Technik entsprechenden Standardmethoden der Dünnschichttechnologie problemlos gefertigt werden können.

Die quantitative Messung kann hier entweder durch simultane Kompensation der drei Komponenten des äußeren Magnetfelds wie im Ausführungsbeispiel des letzten Abschnitts oder durch direkte Messung der an jedem einzelnen SQIF abfallenden Spannung erfolgen. Letztere Messmethode ist für bestimmte Anwendungen ein weiterer Vorteil solcher Anordnungen, da dann keine Kompensationsvorrichtungen notwendig sind.

In zwei weiteren nicht dargestellten Ausführungsbeispielen ist der Vektor-SQIF entsprechend dem letzten oder vorletzten Abschnitt so aufgebaut, dass die Flächennormalen der einzelnen SQIFs oder die orientierten Flächenelemente $\vec{a}_m$ derart angeordnet sind, dass aus ihnen eine vollständige vektorielle Basis eines zweidimensionalen Unterraumes des dreidimensionalen Raumes gebildet werden kann. Diese Ausführung kann dann von Vorteil sein, wenn das magnetische Feld nur in einer Ebene gemessen werden soll, z.B. wenn es sich um ebene Detektorfelder oder Speicher handelt.

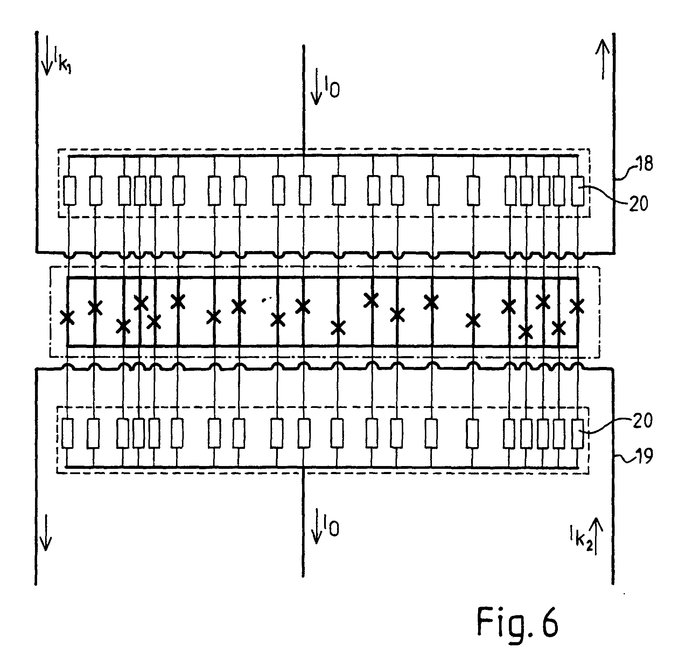

In Fig. 6 ist ein Ausführungsbeispiel eines ebenen SQIFs dargestellt, bei dem das magnetische Kompensationsfeld durch zwei Steuerleitungen 18, 19, welche parallel zum Netzwerk und damit senkrecht zur Richtung des treibenden Stromes liegen, erzeugt wird. Fließt in einer solchen erfindungsgemäßen Anordnung ein Strom $I_{k1}$, $I_{k2}$ durch eine oder beide Steuerleitungen 18, 19, so wird in die Zellen des SQIFs ein durch diesen Strom sehr genau kontrollierbarer magnetischer Fluss bekannter Stärke eingekoppelt. Dieser Fluss kann den durch ein äußeres magnetisches Feld verursachten Fluss derart kompensieren, dass die über den SQIF abfallende Spannung minimal wird. Dieser sogenannte Arbeitspunkt liegt dann immer im absoluten Minimum der Eichkurve $\langle V(\vec{B};I_0)\rangle$ des SQIFs. Über den Wert des Kompensationsstroms kann, da der Abstand zwischen Steuerleitung und Netzwerk bekannt ist, die Stärke des äußeren Magnetfelds direkt bestimmt werden. Auch die Wahl eines anderen Arbeitspunkts innerhalb des Messbereichs des SQIFs ist möglich. Diese Ausführung hat den Vorteil, dass der Operationsbereich des SQIFs, d.h. der Bereich der Magnetfeldstärken, die mit der Vorrichtung gemessen werden können, prinzipiell nur durch Feldstärken, die die Phasenkohärenz zwischen den durch Tunnelbarrieren getrennten supraleitfähigen Bereichen zerstören, nach oben hin begrenzt ist. Ein weiterer Vorteil ist, dass in dieser Ausführung SQIFs auch dann noch voll funktionsfähig betrieben werden können, wenn der eigentliche Messbereich, d.h. der Bereich in dem die Spannungsantwortfunktion ein-eindeutig ist, sehr klein wird. Dies kann dann auftreten, wenn durch fertigungsbedingte Toleranzen Nebenminima der Spannungsantwortfunktion auftreten, deren Spannungswerte sich nicht sehr stark vom Spannungswert des absoluten Minimums unterscheiden. Solange der Messbereich jedoch größer als die Auflösungsgrenze des SQIFs, die typischerweise bei einigen nV liegt, bleibt die Vorrichtung erfindungsgemäß in einer Ausführung mit Kompensationsschaltung voll funktionsfähig. Vorteilhaft an einer Ausführung mit Steuerleitungen ist auch, dass die Kompensationsschaltung on-chip angebracht ist und keine zusätzlichen Fertigungsschritte erfordert. Entsprechend dem derzeitigen Stand der Technik können die Steuerleitungen bei Dünnschichtaufbauten in den über oder den unter den Netzwerk-Zuführungsleitungen liegenden Schichten angebracht werden. Auch das Anbringen von mehreren Steuerleitungen kann von Vorteil sein, etwa wenn zu Präzisionsmessungen einem statischen Kompensationsfeld ein zeitlich variierendes Kompensationsfeld überlagert werden soll.

Für Operationsmodi, bei denen zeitlich variierende Kompensationsfelder verwendet werden, sollten erfindungsgemäße SQIFs ihre maximale Empfindlichkeit erreichen. In solchen Modi ist darüber hinaus nicht nur die simultane Bestimmung der Stärke und der Richtung des zu messenden Feldes, sondern auch seiner Phasenlage möglich. Dies erlaubt die vollständige Rekonstruktion des gemessenen zeitveränderlichen Signals und damit die Erstellung einer identischen Kopie dieses Signals. Der Vorteil der Vorrichtungen liegt darin, dass solche Kopien ohne jeden Informationsverlust verstärkt und weitergeleitet werden können.

In Fig. 6 symbolisieren wiederum die Kreuze die Josephsonkontakte. Mit dem Bezugszeichen 20 sind symbolisch dargestellte bus-bar-Widerstände bezeichnet. Die strichpunktierte Linie beschreibt die Begrenzung des notwendigerweise supraleitenden Teils des Netzwerks.

In einer nicht dargestellten Ausführung für Präzisionsmessungen ist die Kompensationsschaltung außerhalb des SQIFs angebracht und besteht aus einem Spulenpaar, welches derart orientiert ist, dass der SQIF in einer Ebene senkrecht zur Achse des Spulenpaars zwischen den beiden Spulen liegt. Solche Kompensationsschaltungen können den Vorteil haben, dass das magnetische Kompensationsfeld am Ort des SQIFs eine sehr hohe Homogenität aufweist und dadurch äußerst präzise Messungen ermöglicht. Auch Ausführungen, bei denen lokal, d.h. durch Steuerleitungen, und durch außerhalb des SQIFs angebrachte Kompensationsschaltungen, kompensiert wird, können von Vorteil sein, um den Einfluss von Störungen, wie etwa Rauschen und Fluktuationen, zu minimieren. Erfindungsgemäße SQIFs, welche über Kompensationsschaltungen, etwa in Form von Steuerleitungen verfügen, können auch als Logikbauelemente (Aktoren) für ultraschnelle Hochleistungsrechner verwendet werden. SQIFs mit zwei lokalen Steuerleitungen können ODER-Logikbausteine bereitstellen, die nur dann schalten, wenn durch beide Steuerleitungen ein exakt gleicher paralleler Strom fließt. Die Schaltzeiten solcher Aktoren liegen dabei im Bereich der Netzwerkfrequenz, d.h. im GHz bis THz Bereich. Ein Vorteil solcher Logikbausteine liegt dabei auch darin, dass sie gleichzeitig als Verstärker wirken, da sehr kleine Steuerströme bereits zur maximalen Spannungsantwort führen, die für heutzutage typische Josephsonkontakte mehrere hundert $\mu V$ bis $mV$ beträgt.

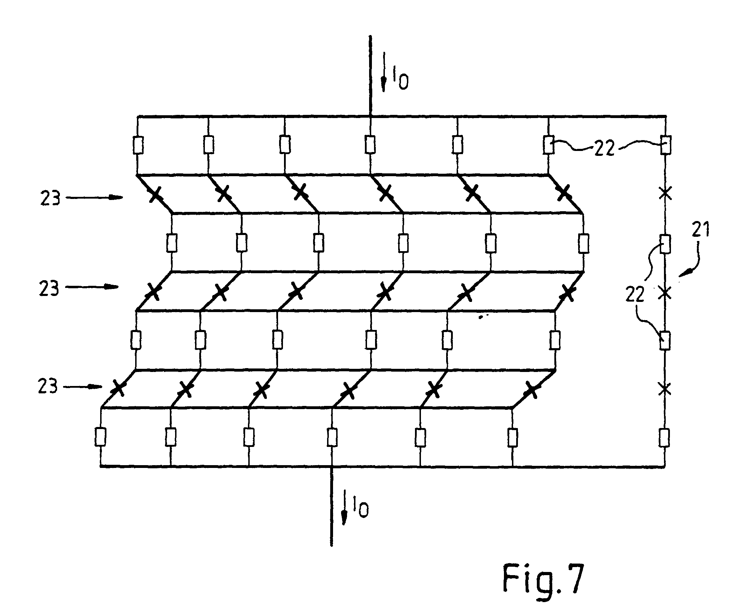

Durch eine Serienschaltung von SQIFs, wie dies in Fig. 7 dargestellt ist, die durch eine aktive Steuerleitung 21, welche ihrerseits wiederum Josephsonkontakte enthält, miteinander gekoppelt sind, kann die Empfindlichkeit bzw. der Verstärkungsfaktor der erfindungsgemäßen Anordnungen vervielfacht werden. Die Kreuze symbolisieren Josephsonkontakte. Mit dem Bezugszeichen 22 sind symbolisch dargestellte bus-bar-Widerstände bezeichnet. Die dick ausgezogenen Linien innerhalb des Netzwerks repräsentieren supraleitende Verbindungen und symbolisieren den supraleitenden Bereich 23, der auch die Josephsonkontakte enthält.

Die aktive Steuerleitung 21 bewirkt hierbei eine Synchronisation des eindimensionalen SQIF-arrays auch bei stark abweichenden Struktur faktoren der verschiedenen SQIF-Abschnitte und Parameterinhomogenitäten. Sind die Fertigungstoleranzen klein, kann unter Umständen auf die aktive Steuerleitung auch verzichtet werden. Der Vorteil solcher SQIF-arrays, die auch zweidimensional ausgelegt sein können, liegt darin, dass die Auflösungsgrenze der Vorrichtung mit der Zahl der SQIF-Abschnitte 23 abnimmt und der Verstärkungsfaktor mit der Zahl der SQIF-Abschnitte anwächst. Im Bereich der Magnetfeldmessung sollten sich mit solchen Anordnungen bei optimaler Wahl des Operationsmodus zum Beispiel Auflösungsgrenzen erreichen lassen, die viele Größenordnungen niedriger sind als die bei konventionellen SQUID-Systemen. Auch SQIF-arrays lassen sich mit den dem Stand der Technik entsprechenden Fertigungsverfahren problemlos herstellen.

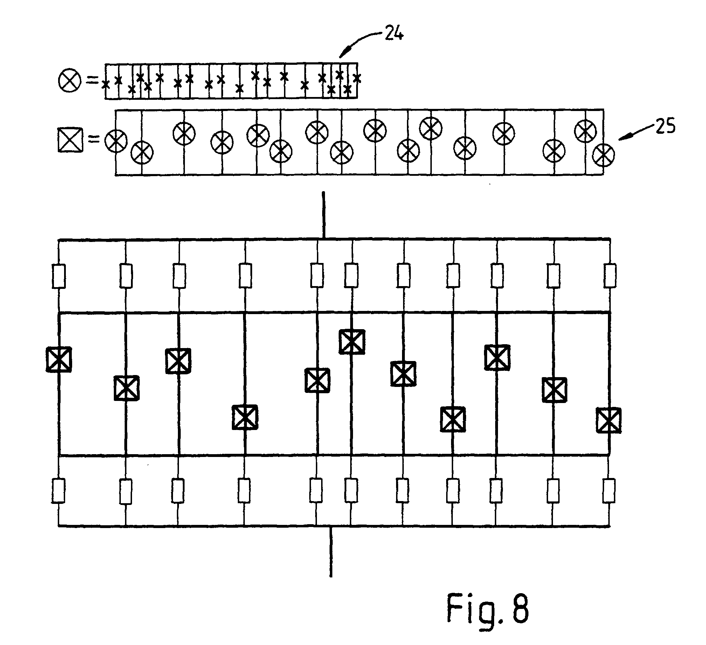

Ein Ausführungsbeispiel bei dem mehrere SQIF-Abschnitte 24 in einem hierarchisch gegliederten SQIF-array verschaltet sind, ist in Fig. 8 gezeigt. Die Basiselemente eines solchen hierarchischen SQIF-arrays sind hier identische Basis-SQIFs 24 mit identischem Strukturfaktor. Diese Basis-SQIFs sind auf einer zweiten Hierarchieebene wiederum in Form eines SQIFs 25 angeordnet, welcher erneut als Basis-SQIF 25 für eine dritte Hierarchieebene dient. Auch Anordnungen mit mehr als drei Hierarchieebenen ($k$=1,2,3,...) sind möglich. Der Vorteil solcher Anordnungen liegt darin, dass je nach den Verhältnissen der orientierten Flächenelemente des Basis-SQIFs und dem oder der SQIFs höherer Hierarchieebenen, bedingt durch die im Allgemeinen verschiedenen Strukturfaktoren auf den verschiedenen Ebenen, die Interferenzmuster, die auf den verschiedenen Ebenen erzeugt werden, wiederum zu einem Gesamtmuster interferieren, was eine außerordentlich hohe Auflösung ermöglicht. Da die orientierten Flächenelemente $\vec{a}_m$ in den verschiedenen Hierarchieebenen unterschiedlich ausgerichtet werden können, ist das resultierende Interferenzmuster zudem extrem sensitiv bezüglich der Richtung des äußeren Feldes. Nach dem derzeitigen Stand der Fertigungstechnik können solche mehrdimensional ausgelegten SQIF-Systeme nicht on-chip realisiert werden. Es ist jedoch möglich, die einzelnen ebenen Bestandteile eines mehrdimensionalen SQIF-Systems mit herkömmlichen Methoden der Dünnschichttechnologie herzustellen und diese dann mit supraleitenden twisted-pair-Kabeln so zu verbinden, dass ein Gesamtsystem der beschriebenen Art entsteht. Solche supraleitenden twisted-pair-Kabel haben dabei den Vorteil, dass in sie kein effektiver Fluss eindringt. Die Verbindung verschiedener Teile eines SQIF-Systems mit solchen supraleitenden twisted-pair-Kabeln beeinflusst die erfindungsgemäße Funktionsfähigkeit des Gesamt-SQIFs daher nicht, da in G1. 6 das Kabel lediglich als orientiertes Flächenelement mit verschwindend kleiner Fläche eingeht.

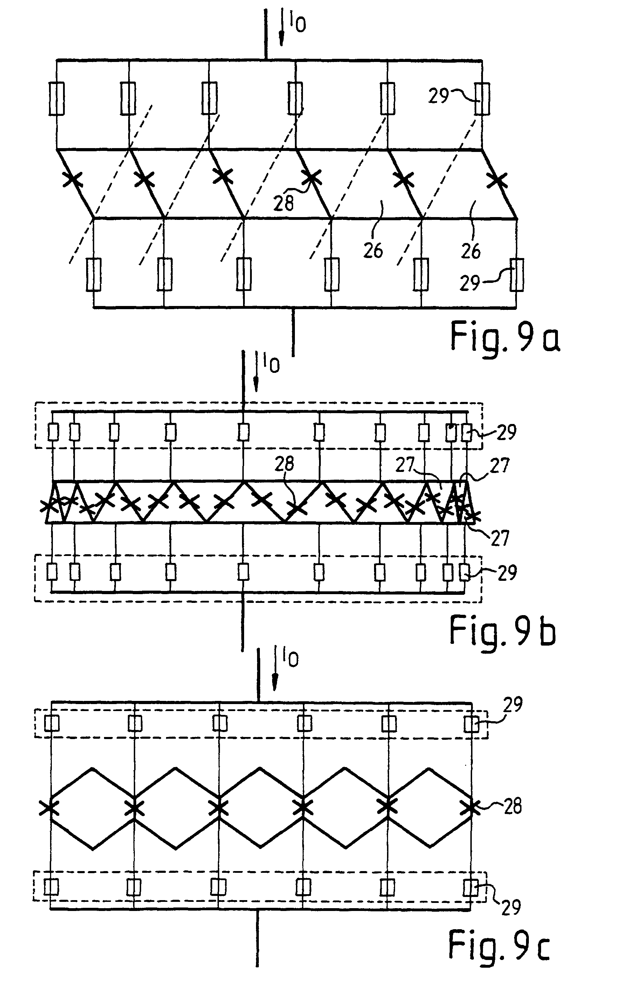

Ein Ausführungsbeispiel, das zeigt, wie die zwischen den verschiedenen Netzwerkzellen wirksamen induktiven Kopplungen minimiert werden können, ist in Fig. 9a dargestellt. Solche induktiven Kopplungen können die Empfindlichkeit der Vorrichtung vermindern, wenn das Netzwerk aus sehr vielen Zellen besteht. Da durch jeden Kontakt ein überkritischer Strom fließt, erzeugt die resultierende Stromverteilung in diesem Fall ein Eigenfeld, das unter Umständen nicht vernachlässigt werden kann. Durch erfindungsgemäße Ausführungen, wie sie etwa in Fig. 9b dargestellt sind, lässt sich der Einfluss der Eigenfelder stark reduzieren. In Fig. 9a und 9b sind die Leiterbahnen der Netzwerkzellen 26, 27 so ausgeführt, dass der durch einen Netzwerkkontakt 28 fließende Strom in der jeweils übernächsten Netzwerkzelle nur einen vernachlässigbaren Fluss induziert, da das magnetische Feld eines stromdurchflossenen kurzen Leiterstücks im Wesentlichen auf einen Bereich senkrecht zum Leiterstück beschränkt ist. Da für $\Phi$=0 jeder Kontakt von einem Strom gleicher Stärke durchflossen wird, verschwinden für diesen Fall alle Induktivitäten und das globale Minimum der Spannungsantwortfunktion entspricht dem nach Gl. 8. Um die Eigenfelder der stromzuführenden und abführenden Leitungen zu minimieren, wird der Treiberstrom $I_0$ durch dem Stand der Technik entsprechende bus-bar-Widerstände 29, deren Entfernung zum Netzwerk groß genug gewählt werden kann, zuund wieder abgeführt. Eine alternative, die gegenseitigen induktiven Einflüsse ebenfalls minimierende Ausführung eines SQIF ist in Fig. 9c dargestellt.

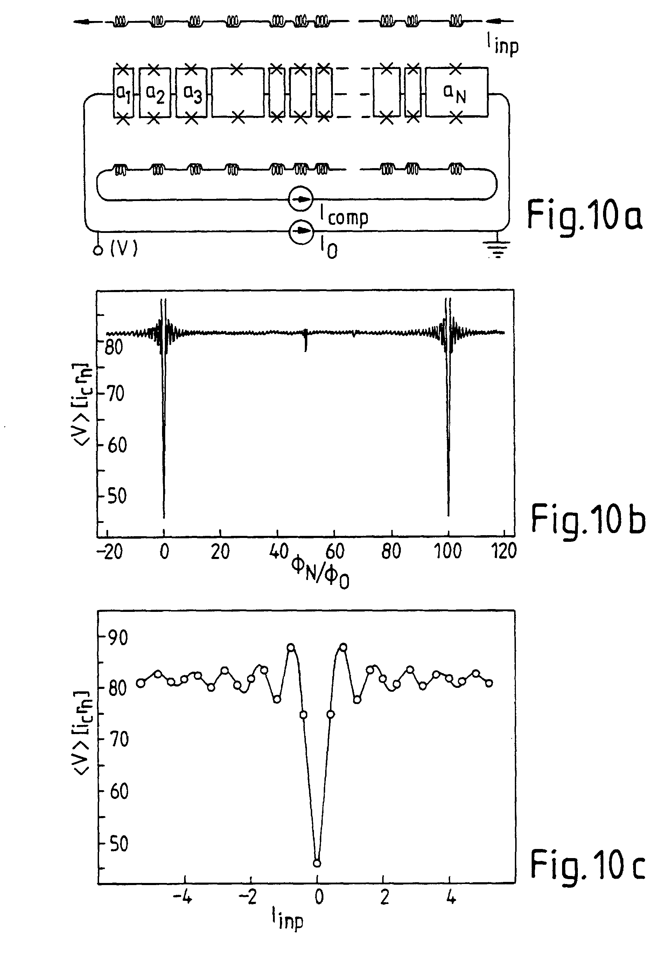

Ein Ausführungsbeispiel, bei dem die verschiedenen Netzwerkzellen in Serie geschaltet sind, ist in Fig. 10a dargestellt. Die orientierten Flächenelemente $\vec{a}_m$ sind auch hier so gewählt, dass die Spannungsantwortfunktion des Netzwerks nicht periodisch ist oder nur eine im Vergleich zu $\Phi_0$ sehr große Periode besitzt. Im Fall einer nichtperiodischen Spannungsantwortfunktion liegt genau bei $\vec{B} = 0$ das globale absolute Minimum dieser Spannungsantwortfunktion. In Fig. 10b ist eine typische Spannungsantwortfunktion einer Serienschaltung für $N = 100$ Netzwerkzellen $a_1$ bis $a_{100}$ und sehr großer Periode dargestellt.

Solche Ausführungen besitzen den Vorteil, dass sich bedingt durch die Serienschaltung die Spannungsantwortfunktionen der einzelnen Netzwerkzellen addieren. Dadurch entsteht ein Quanten-Interferenz-Filter mit einem sehr großen Spannungshub, der bis in den Bereich mehrerer mV oder gar V kommen kann. Im Gegensatz zur Parallelschaltung ergibt sich dabei jedoch keine Verminderung der Breite der Spannungsantwortfunktion (Varianz) um $\vec{B} = 0$ im Vergleich zu konventionellen zwei-Kontakt-SQUIDs. Da der Abstand benachbarter Netzwerkschlaufen in Serienanordnungen jedoch beliebig gewählt werden kann, ohne die Quanteninterferenzbedingung zu verletzen, können mit solchen Anordnungen die parasitären gegenseitigen Induktivitäten minimiert werden. Zudem können Serienschaltungen bei der Fertigung technisch bedingte Vorteile haben. Insbesondere ist eine erhöhte Packungsdichte möglich, was bei der Integration der Schaltungen auf einem Chip von Vorteil sein kann.

Die theoretische Beschreibung von Serien-SQIFs kann mit Hilfe von Gleichung 8 erfolgen, da ein Serien-SQIF die einfachste Realisierung eines zweidimensionalen SQIF-arrays darstellt. Für identische Netzwerkkontakte ist die über einer einzelnen Netzwerkzelle für einen überkritischen Treiberstrom $I_0 > 2i_c$ abfallende mittlere Gleichspannung durch

$$\langle V \rangle_n = i_c\, r_n\, \sqrt{\left(\frac{I_0}{2\,i_c}\right)^2 - \left|\cos\left(\pi\frac{\Phi_n}{\Phi_0}\right)\right|^2} \qquad (9)$$

gegeben, wobei $\Phi_n = \langle \vec{B}, \vec{a}_n \rangle$ gilt. Die über das gesamte Serienarray abfallende mittlere Gleichspannung $\langle V \rangle$ ergibt sich daraus zu

$$\langle V \rangle = \sum_{n=1}^{N} \langle V \rangle_n \qquad (10)$$

Zwar kann, bedingt durch die Serienanordnung der Netzwerkzellen $\vec{a}_n$, nicht direkt ein Strukturfaktor wie für die Parallelanordnung definiert werden, durch entsprechende Wahl der Folge $\{\vec{a}_n\}$ ist es jedoch auch hier möglich, den Verlauf der Spannungsantwortfunktion und insbesondere den Mess- bzw. Operationsbereich einzustellen.

Im Ausführungsbeispiel der Fig. 10b etwa wurden die orientierten Flächenelemente $\vec{a}_n$ in einer ebenen Serienanordnung entsprechend der arithmetischen Relation

$$a_n = \frac{n}{N} a_N \qquad (11)$$

gewählt, wobei $a_n = |\vec{a}_n|$ gilt und $a_N$ die größte Fläche des Serien-SQIFs mit $N$ Netzwerkzellen und $2N$ Kontakten bezeichnet. Eine solche Wahl hat z.B. den Vorteil, dass das Maximum der Spannungsantwortfunktion direkt auf das Minimum folgt (vgl. Fig. 10b) und so der Spannungshub maximal wird.

In Fig. 10a ist neben dem Serien-SQIF eine typische Ankoppelund Steuerschaltung schematisch eingezeichnet. Bei entsprechender Auslegung wird durch den Kompensationsstrom $I_{comp}$ am Ort der einzelnen Netzwerkzellen ein magnetisches Kompensationsfeld erzeugt, das ein äußeres Feld und/oder das Feld, das durch den Strom $I_{inp}$ erzeugt wird, kompensiert. Dies ermöglicht den Betrieb des SQIF im extrem empfindlichen Nullabgleichmodus. Der Strom $I_{inp}$ ist dabei etwa der input-Strom einer pick-up-loop- oder einer anderen Signalquelle.

Serien-SQIFs können auch deshalb von großem Vorteil sein, weil das Eigenrauschen der Schaltung, etwa bei ihrer Verwendung als (Strom-) Verstärker, nur proportional zu $\sqrt{N}$ anwächst, während der Spannungshub proportional zu $N$ anwächst. Dies ist deshalb der Fall, weil das Spannungsrauschen der unterschiedlichen Netzwerkzellen, bzw. der Josephsonkontakte in diesen Zellen, nicht korreliert ist (reine Stromkopplung), und sich daher nur inkohärent überlagert. Mit Serien-SQIFs oder allgemeinen SQIF-Arrays lassen sich dadurch etwa extrem rauscharme Verstärker realisieren. Eine typische Strom-Spannungskennlinie eines solchen Verstärkerbauteils, das durch einen SQIF realisiert werden kann, ist in Fig. 10c dargestellt. Je nach Auslegung des SQIF können in diesem Operationsmodus auch sehr kleine Ströme ($< 10^{-12}$ A) detektiert bzw. verstärkt werden. Weitere Vorteile solcher Verstärkerbauteile sind ihre sehr schnellen Schaltzeiten und ihre Anwendbarkeit bis zu sehr hohen Frequenzen.

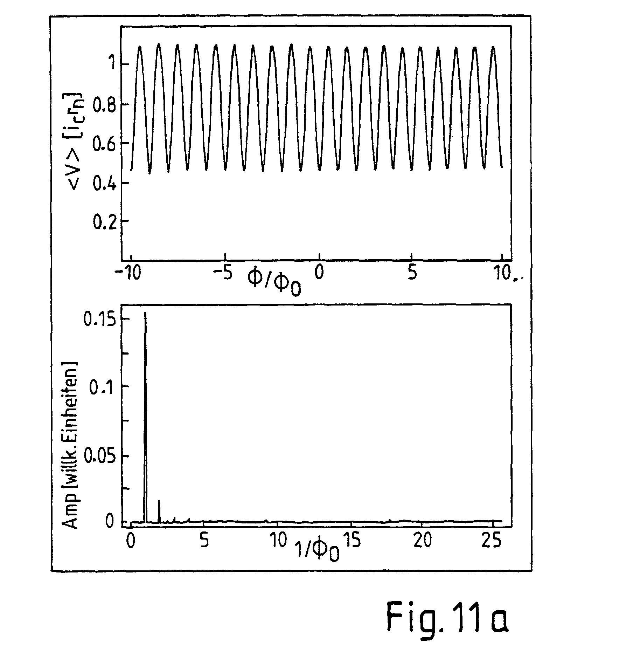

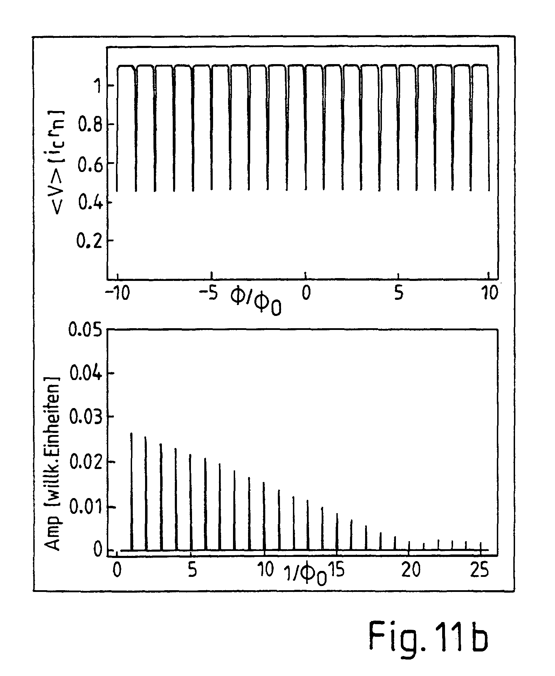

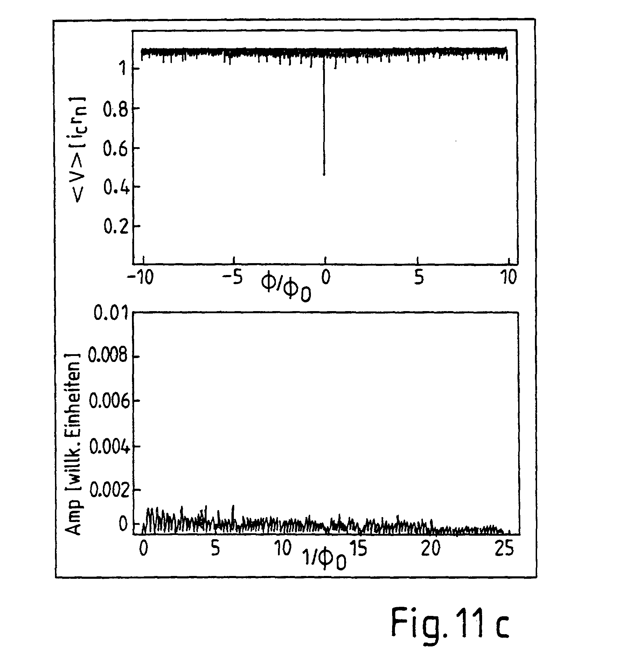

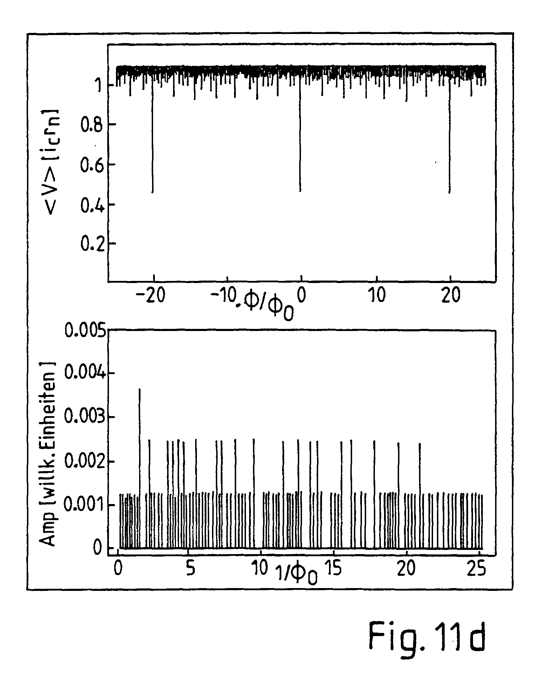

Die Periodizitätseigenschaften der Spannungsantwortfunktion sind ein wesentliches Merkmal erfindungsgemäßer Quanten-Interferenz-Filter. Das Frequenzspektrum der Spannungsantwortfunktionen von erfindungsgemäßen SQIFs in Bezug auf den magnetischen Fluss unterscheidet sich daher eindeutig von konventionellen, dem Stand der Technik entsprechenden SQUID-Interferometern. Dieser Sachverhalt ist in den Fig. 11a bis 11d anhand von typischen Frequenzspektren von dem Stand der Technik entsprechenden SQUIDs (Fig. 11a und 11b) und von erfindungsgemäßen Quanten-Interferenz-Filtern (Fig. 11c und 11d) dargestellt.

Fig. 11a zeigt im oberen Bild die typische Spannungsantwortfunktion eines herkömmlichen SQUID. Die $\langle V(\Phi)\rangle$-Kurve ist periodisch mit der Periode $\Phi_0$. Das zugehörige Frequenzspektrum im unteren Bild der Fig. 11a zeigt dementsprechend eine bei weitem dominierende Amplitude bei 1 $\Phi_0$. Da die Spannungsantwortfunktion eines SQUID nicht harmonisch ist (vgl. Gl.8), treten zusätzlich noch höhere harmonische Moden bei $2\Phi_0$ und $3\Phi_0$ auf, die jedoch lediglich eine sehr kleine Amplitude besitzen. Das Frequenzspektrum herkömmlicher SQUIDs wird damit vom $\Phi_0$-periodischen Beitrag dominiert. Wie Fig. 11b zeigt, ist dies auch bei Mehrschlaufenanordnungen, welche aus identischen Netzwerkzellen aufgebaut sind, der Fall, und zwar unabhängig davon, ob es sich um Serienanordnungen oder Parallelanordnungen identischer SQUID-Schlaufen handelt. Auch bei Parameterimperfektionen oder geometrischen Imperfektionen zeigen dem Stand der Technik entsprechende Quanten-Interferometer immer ein diskretes Frequenzspektrum, das vom $\Phi_0$-periodischen Beitrag dominiert wird. Bei Imperfektionen zusätzlich auftreten kann lediglich ein zusätzliches kontinuierliches Spektrum, das von den Imperfektionen herrührt und von der Art der Imperfektionen abhängt.

Erfindungsgemäße Quanten-Interferenz-Filter hingegen besitzen keinen dominanten $\Phi_0$-periodischen Beitrag im Frequenzspektrum ihrer Spannungsantwortfunktionen. Dieser Sachverhalt ist in Fig. 11c und Fig. 11d dargestellt. Die Frequenzspektren in den Fig. 11a bis 11c (untere Bilder) sind in den jeweils gleichen willkürlichen Einheiten aufgetragen, so dass ein direkter Vergleich möglich ist. Die Spannungsantwort und das zugehörige Frequenzspektrum eines erfindungsgemäßen Quanten-Interferenz-Filters, welche keine Periodizität besitzt, ist in Fig. 11c gezeigt. Das Spektrum ist praktisch kontinuierlich, ein diskretes Spektrum existiert nicht. Insbesondere existiert kein signifikanter $\Phi_0$ periodischer Beitrag. Die Amplituden des praktisch kontinuierlichen Spektrums sind um zwei bzw. eine Größenordnung kleiner als bei den herkömmlichen Anordnungen nach Fig. 11a bzw. Fig. 11b. In Fig. 11d ist die Spannungsantwortfunktion und das zugehörige Spektrum eines erfindungsgemäßen Quanten-Interferenz-Filters dargestellt, welcher eine technisch bedingte Periodizität besitzt. Die Spannungsantwortfunktion hat die Eigenschaft, dass ihre Periode sehr viel größer als $\Phi_0$ ist und das Frequenzspektrum besitzt einen diskreten Anteil mit einer sehr kleinen Amplitude bei der Periode $\Phi_0$. Diese Amplitude bei der Periode $\Phi_0$ ist nicht signifikant und liefert jedenfalls keinen dominanten Beitrag zum Frequenzspektrum. Das diskrete Spektrum ist zudem wiederum dadurch ausgezeichnet, dass dessen Amplituden im Vergleich zu den herkömmlichen Anordnungen um ein bis zwei Größenordnungen kleiner sind.

Die Frequenzspektren von erfindungsgemäßen Quanten-Interferenz-Filtern sind im Hinblick auf den $\Phi_0$-periodischen Beitrag des Frequenzspektrums robust. Parameterimperfektionen oder geometrische Imperfektionen verändern die oben beschriebenen qualitativen Eigenschaften von erfindungsgemäßen Anordnungen nicht.

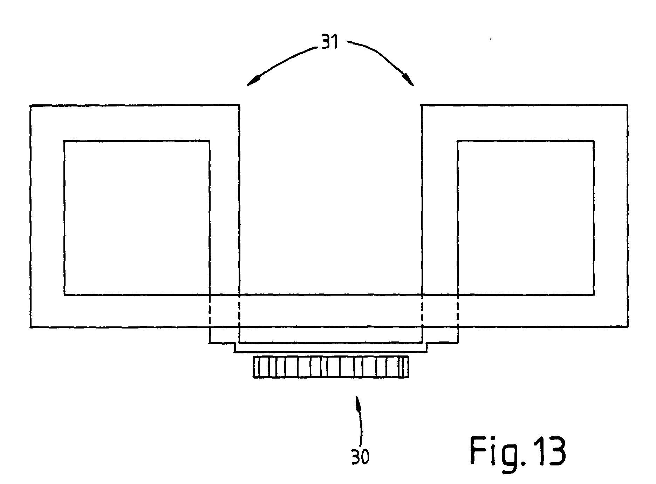

In Fig. 13 ist ein Ausführungsbeispiel eines ebenen SQIF 30 schematisch dargestellt, das mit einer supraleitenden Einkoppelschlaufe (pick-up-loop) versehen ist. Solche Einkoppelschlaufen verstärken das primäre magnetische Feld, indem sie den durch dieses Feld in ihrem Innern erzeugten Fluss nach außen verdrängen. Solche Vorrichtungen haben den Vorteil, dass durch eine geeignete Anordnung das primäre magnetische Feld am Ort des SQIF stark verstärkt werden kann. Ein weiterer Vorteil von SQIFs besteht darin, dass die Gesamtfläche von SQIFs so ausgelegt werden kann, dass die Impedanz-Fehlanpassung zwischen pick-up-loop und SQIF minimiert wird. Die Empfindlichkeit und die Auflösung von SQIFs kann durch solche Vorrichtungen erheblich gesteigert werden. Anstatt eines pick-up-loop können auch supraleitende Flächen (sog. washer) verwendet werden, welche ebenfalls zu den genannten Vorteilen führen. Auch die Ankopplung einer Gradiometerschlaufe ist möglich und führt zu den genannten Vorteilen bei der Messung von Magnetfeldgradienten. Bei der Detektion zeitveränderlicher elektromagnetischer Felder sind geeignet ausgelegt supraleitende Einkoppelschlaufen ebenfalls von Vorteil, da sie gleichzeitig als Empfangsantennen dienen können.

**Patentansprüche**

1. Vorrichtung zur hochauflösenden Messung von magnetischen Feldern bzw. zur quantitativen Bestimmung der Stärke der magnetischen Induktion mit hoher Genauigkeit mit einem Netzwerk (1, 2) von Übergängen (3, 4) zwischen Supraleitern (5, 6), die Josephsoneffekte zeigen, im Folgenden Kontakte genannt, wobei das Netzwerk geschlossene Maschen (7, 7a bis 13, 14a), im Folgenden mit Zellen bezeichnet, umfasst, die jeweils mindestens zwei Kontakte (3, 4) aufweisen, welche Kontakte supraleitend verbunden sind, und wobei das Netzwerk wenigstens drei solche Zellen beinhaltet, über jede der wenigstens drei Zellen bei Versorgung mit einem konstanten überkritischen Strom eine magnetfeldabhängige Spannung abfällt, die wenigstens drei Zellen supraleitend und/oder nicht supraleitend in Verbindung stehen, und die Kontakte (3, 4) der wenigstens drei Zellen derart galvanisch an einer Strom- und/oder Spannungsquelle angeschlossen sind und mit einem überkritischen Strom versorgt werden können, dass über dem Netzwerk eine magnetfeldabhängige Spannung abfällt, welche Spannung bei einer Versorgung mit einem konstanten überkritischen Strom einen nicht verschwindenden Gleichspannungsanteil besitzt, **dadurch gekennzeichnet, dass** die wenigstens drei Zellen gezielt auf eine Weise geometrisch unterschiedlich ausgestaltet und dergestalt angeordnet sind, dass die bei einem am Ort des Netzwerks vorhandenen magnetischen Feld von den Zellen eingeschlossenen magnetischen Flüsse gezielt verschieden und inkommensurabel sind und damit keinen größten gemeinsamen Teiler besitzen, oder, falls ein größter gemeinsamer Teiler existiert, dieser größte gemeinsame Teiler gezielt kleiner oder höchstens gleich dem kleinsten von einer der wenigstens drei Zellen eingeschlossenen magnetischen Fluss ist, und dass bei einer Versorgung mit einem konstanten überkritischen Strom, falls kein größter gemeinsamer Teiler existiert, der Gleichspannungsanteil der über dem Netzwerk abfallenden Spannung nur dann minimal wird, wenn der Betrag des vorhandenen magnetischen Feldes minimal ist und damit der Gleichspannungsanteil in Bezug auf den magnetischen Fluss keine Periode besitzt, oder, falls ein größter gemeinsamer Teiler existiert, die Periode des Gleichspannungsanteils gleich oder größer ist als das mit dem elementaren Flussquant multiplizierte Verhältnis des gesamten von den wenigstens drei Zellen eingeschlossenen Flusses zum größten gemeinsamen Teiler.

2. Vorrichtung nach Anspruch 1, **dadurch gekennzeichnet, dass** jede der wenigstens drei Zellen eine ebene Geometrie aufweist und dass die bei einem am Ort des Netzwerks vorhandenen magnetischen Feld vom magnetischen Feld durchsetzten Flächen der wenigstens drei Zellen verschieden und inkommen Surabel sind und damit keinen größten gemeinsamen Teiler besitzen oder dass, falls ein größter gemeinsamer Teiler existiert, dieser größte gemeinsame Teiler kleiner oder höchstens gleich der vom magnetischen Feld durchsetzten Fläche der kleinsten Zelle ist.

3. Vorrichtung nach einem der vorhergehenden Ansprüche, **dadurch gekennzeichnet, dass** mehrere Zellen ein Netzwerk (1, 2) oder einen Netzwerkabschnitt (24, 25) bilden, in welchem alle Kontakte elektrisch parallel geschaltet sind, so dass die Kontakte galvanisch an eine Strom- und/oder Spannungsquelle anschließbar sind und in der gleichen Richtung mit Strom versorgt werden können.

4. Vorrichtung nach einem der vorhergehenden Ansprüche, **dadurch gekennzeichnet, dass** mehrere Zellen oder Netzwerkabschnitte oder wenigstens eine Zelle und ein Netzwerkabschnitt elektrisch in Reihe geschaltet sind, so dass die Kontakte im Netzwerk galvanisch an eine Strom- und/oder Spannungsquelle anschließbar sind und in der gleichen Richtung mit Strom versorgt werden können.

5. Vorrichtung nach einem der vorhergehenden Ansprüche, **dadurch gekennzeichnet, dass** mehrere Reihenschaltungen von Zellen und/oder Netzwerkabschnitten derart mit supraleitenden twisted-pair-Kabeln und/oder anderen elektrischen Verbindungen elektrisch parallel geschaltet sind, dass die Kontakte im Netzwerk galvanisch an eine Strom- und/oder Spannungsquelle anschließbar sind und in der gleichen Richtung mit Strom versorgt werden können.

6. Vorrichtung nach einem der vorhergehenden Ansprüche, **dadurch gekennzeichnet, dass** die Kontakte (3, 4) als Punktkontakte ausgeführt sind.

7. Vorrichtung nach einem der vorhergehenden Ansprüche, **dadurch gekennzeichnet, dass** die Geometrie der Zellenanordnung derart ausgeführt ist, dass ein magnetisches Übersprechen einer Zelle auf die andere Zelle aufgrund des durch einen in den Zellen fließenden Strom hervorgerufenen magnetischen Eigenfeldes reduziert wird.

8. Vorrichtung nach einem der vorhergehenden Ansprüche, **dadurch gekennzeichnet, dass** das Netzwerk mit einer das magnetische Feld verdrängenden und/oder verstärkenden supraleitenden Schlaufen- und/oder Flächenanordnung derart ausgestattet ist, dass der von einem primären magnetischen Feld in diesen supraleitenden Bereichen erzeugte magnetische Fluss in die Zellen des Netzwerks eingekoppelt wird.

9. Vorrichtung nach einem der vorhergehenden Ansprüche, **dadurch gekennzeichnet, dass** die Zellen des Netzwerks und/oder der Netzwerkabschnitte derart räumlich unterschiedlich ausgerichtet sind, dass wenigstens zwei von drei räumlichen Feldkomponenten eines primären magnetischen Feldes im Netzwerk einen magnetischen Fluss induzieren können.

10. Vorrichtung nach einem der vorhergehenden Ansprüche, **dadurch gekennzeichnet, dass** der die Kontakte versorgende Strom in das Netzwerk durch ohmsche Widerstände, welche insbesondere als bus-bar-widerstände ausgeführt sind, eingespeist und/oder wieder abgeführt wird.

11. Vorrichtung nach einem der vorhergehenden Ansprüche, **dadurch gekennzeichnet, dass** das Netzwerk mit einer Kompensationsschaltung zur Erzeugung eines sekundären magnetischen Feldes derart ausgestattet ist, dass der durch ein primäres magnetisches Feld erzeugte magnetische Fluss durch einen Teil der Netzwerkzellen oder alle Netzwerkzellen kontrolliert kompensiert werden kann, oder dass am Ort jeder Netzwerkzelle oder eines Teils der Netzwerkzellen ein steuerbares statisches oder zeitveränderliches Magnetfeld erzeugt werden kann.

**Claims**

1. Device for high resolution measurement of magnetic fields or for the quantitative determination of the strength of the magnetic induction with high accuracy with a network (1, 2) of transitions (3, 4) between superconductors (5, 6) which exhibit Josephson effects, hereinafter called junctions, the network comprising closed meshes (7, 7a to 13, 14a) hereinafter called cells, each comprising at least two junctions (3, 4) which junctions are connected in a superconducting fashion and the network containing at least three cells of this type, a magnetic field-dependent voltage dropping over each of the at least three cells during when supplied with a constant supercritical current, the at least three cells being connected in a superconducting and/or nonsuperconducting fashion and the junctions (3, 4) of the at least three cells being galvanically connected to a current and/or voltage source and being capable of being supplied with a suitable current in such a way, that a magnetic field-dependent voltage drops over the network, which voltage in the case of supply with a constant supercritical current has a non-vanishing direct voltage portion, **characterised in that** the at least three cells are purposefully configured differently geometrically in such a way and are arranged in such a way that the magnetic fluxes enclosed by the cells in the case of an existing magnetic field at the location of the network are purposefully different and incommensurable and therefore do not have any greatest common divisor or, if a greatest common divisor exists, this greatest common divisor is purposefully smaller than or at most equal to the smallest magnetic flux enclosed by one of the at least three cells, and **in that** when supplied with a constant supercritical current, if no greatest common divisor exists, the direct current portion of the voltage dropping over the network is minimal only when the value of the magnetic field present is minimal and therefore the direct current portion has no period with respect to the magnetic flux, or, if a greatest common divisor exists, the period of the direct current portion is equal to or larger than the ratio of the entire flux enclosed by the at least three cells multiplied by the elementary flux quantum to the greatest common divisor.

2. Device according to claim 1, **characterised in that** each of the at least three cells has a plane geometry and **in that** the areas of the at least three cells penetrated by the magnetic field if a magnetic field is present at the site of the network are different and incommensurable and therefore have no greatest common divisor or **in that**, if a greatest common divisor exists, this greatest common divisor is smaller than or at most equal to the area of the smallest cell penetrated by the magnetic field.

3. Device according to any one of the preceding claims, **characterised in that** a plurality of cells form a network (1, 2) or a network portion (24, 25), in which all the junctions are connected electrically in parallel, so the junctions can be galvanically connected to a current and/or voltage source and can be supplied with current in the same direction.

4. Device according to any one of the preceding claims, **characterised in that** a plurality of cells or network portions or at least one cell and one network portion are electrically connected in series, so the junctions in the network can be galvanically connected to a current and/or voltage source and can be supplied with current in the same direction.

5. Device according to any one of the preceding claims,
   **characterised in that** a plurality of series connections of cells and/or network sections are connected electrically in parallel with the aid of superconducting twisted-pair cables and/or other electric connections in such a way that the junctions in the network can be galvanically connected to a current and/or voltage source and can be supplied with current in the same direction.

6. Device according to any one of the preceding claims, **characterised in that** the junctions (3, 4) are designed as point junctions.

7. Device according to any one of the preceding claims, **characterised in that** the geometry of the cell arrangement is designed so as to reduce magnetic crosstalk from one cell to the other cell on the basis of the magnetic self-field produced by a current flowing in the cells.

8. Device according to any one of the preceding claims, **characterised in that** the network is fitted with a superconducting loop arrangement and/or planar arrangement, which displaces the magnetic field and/or strengthens it in such a way that the magnetic flux produced by a primary magnetic field in these superconducting regions is coupled into the cells of the network.

9. Device according to any one of the preceding claims, **characterised in that** the cells of the network and/or the network sections are aligned in a spatially differing fashion in such a way that at least two of three spatial field components of a primary magnetic field can induce a magnetic flux in the network.

10. Device according to any one of the preceding claims, **characterised in that** the current supplying the junctions is fed into and/or led off again from the network by ohmic resistors which are designed, in particular, as busbar resistors.

11. Device according to any one of the preceding claims, **characterised in that** the network is fitted with a compensation circuit for producing a secondary magnetic field in such a way that the magnetic flux produced by a primary magnetic field can be compensated in a controlled fashion in a portion of the network cells or in all the network cells, or **in that** a controllable static or time-variant magnetic field can be produced at the location of each network cell or a portion of the network cells.

**Revendications**

1. Dispositif pour la mesure à haute résolution de champs magnétiques ou pour la détermination quantitative de l'intensité de l'induction magnétique avec une précision élevée, comportant un réseau (1, 2) de connexions (3, 4) entre des supraconducteurs (5, 6), qui présentent des effets Josephson, dénommés par la suite contacts, le réseau comportant des mailles fermées (7, 7a à 13, 14a), désignées ci-après comme cellules, qui présentent à chaque fois au moins deux contacts (3, 4), lesquels contacts sont reliés de façon supraconductrice, et le réseau comportant au moins trois telles cellules, par l'intermédiaire de chacune des au moins trois cellules, lors de l'alimentation avec un courant supercritique constant, une tension dépendant du champ magnétique chute, les au moins trois cellules étant reliées de façon supraconductrice et/ou non supraconductrice et les contacts (3, 4) des au moins trois cellules étant raccordés de façon galvanique à une source de courant et/ou de tension et pouvant être alimentés par un courant supercritique, de sorte que, par l'intermédiaire du réseau, une tension dépendant du champ magnétique chute, laquelle tension, lors d'une alimentation par un courant constant supercritique, possède une portion de tension continue ne disparaissant pas, **caractérisé en ce que** les au moins trois cellules sont réalisées, de façon souhaitée, d'une manière géométriquement différente et sont agencées de sorte que les flux magnétiques enfermés par les cellules pour un champ magnétique présent au lieu du réseau sont, de façon souhaitée, différents et incommensurables et ne possèdent ainsi pas de plus grand dénominateur commun ou, dans le cas où un plus grand dénominateur commun existe, ce plus grand dénominateur commun est, de façon souhaitée, plus petit ou au plus égal au plus petit flux magnétique enfermé par une des au moins trois cellules, et **en ce que**, pour une alimentation avec un courant supercritique constant, dans le cas où il n'existe pas de plus grand dénominateur commun, la portion de tension constante de la tension chutant sur le réseau est minimale uniquement lorsque la valeur du champ magnétique existant est minimale et, ainsi, la portion de tension constante, relativement au flux magnétique, ne possède aucune période ou, dans le cas où un plus grand dénominateur commun existe, la période de la portion de tension constante est identique ou supérieure au rapport multiplié par le quantum de flux élémentaire du flux global enfermé par les au moins trois cellules vis-à-vis du plus grand dénominateur commun.

2. Dispositif selon la revendication 1,
**caractérisé en ce que** chacune des au moins trois cellules présente une géométrie plane et **en ce que** les surfaces traversées par le champ magnétique pour un champ magnétique existant au lieu du réseau des au moins trois cellules sont différentes et incommensurables et ne possèdent ainsi aucun plus grand dénominateur commun, ou **en ce que**, dans le cas où un plus grand dénominateur commun existe, ce plus grand dénominateur commun est plus petit ou au plus égal à la surface traversée par le champ magnétique de la plus petite cellule.

3. Dispositif selon une des revendications précédentes,

**caractérisé en ce que** plusieurs cellules forment un réseau (1, 2) ou un tronçon de réseau (24, 25), dans lequel tous les contacts sont montés électriquement en parallèle, de sorte que les contacts peuvent être raccordés de façon galvanique à une source de courant et/ou une source de tension et peuvent être alimentés par du courant dans le même sens.

4. Dispositif selon une des revendications précédentes,
**caractérisé en ce que** plusieurs cellules ou tronçons de réseau ou au moins une cellule et un tronçon de réseau sont montés électriquement en série, de sorte que les contacts dans le réseau peuvent être raccordés galvaniquement à une source de courant et/ou une source de tension et peuvent être alimentés par du courant dans le même sens.

5. Dispositif selon une des revendications précédentes,
**caractérisé en ce que** plusieurs circuits en série de cellules et/ou tronçons de réseau sont montés électriquement en parallèle avec des câbles supraconducteurs et/ou d'autres liaisons électriques, de sorte que les contacts dans le réseau peuvent être raccordés de façon galvanique à une source de courant et/ou de tension et peuvent être alimentés en courant dans le même sens.

6. Dispositif selon une des revendications précédentes,
**caractérisé en ce que** les contacts (3, 4) sont réalisés comme contacts ponctuels.

7. Dispositif selon une des revendications précédentes,
**caractérisé en ce que** la géométrie de l'agencement des cellules est telle qu'une diaphonie magnétique d'une cellule à l'autre cellule est réduite sur la base du champ magnétique propre provoqué par un courant circulant dans les cellules.

8. Dispositif selon une des revendications précédentes,
**caractérisé en ce que** le réseau est muni d'un agencement de surface et/ou de boucle supraconducteur amplifiant et/ou supprimant le champ magnétique, de sorte que le flux magnétique engendré dans ces zones supraconductrices par un champ magnétique primaire est couplé dans les cellules du réseau.

9. Dispositif selon une des revendications précédentes,
**caractérisé en ce que** les cellules du réseau et/ou des tronçons de réseau sont orientées de façon spatialement différente, de sorte qu'au moins deux des trois composantes de champ spatiales d'un champ magnétique primaire peuvent induire un flux magnétique dans le réseau.

10. Dispositif selon une des revendications précédentes,
**caractérisé en ce que** le courant alimentant les contacts est alimenté dans le réseau par des résistances ohmiques, qui sont réalisées en particulier comme résistances à barre collectrice, et/ou est à nouveau évacué de celui-ci.

11. Dispositif selon une des revendications précédentes,
**caractérisé en ce que** le réseau est muni d'un circuit de compensation pour engendrer un champ magnétique secondaire, de sorte que le flux magnétique engendré par un champ magnétique primaire peut être compensé, de façon commandée, dans une partie des cellules du réseau ou dans toutes les cellules du réseau, ou **en ce que**, au lieu de chaque cellule du réseau ou d'une partie des cellules du réseau, il peut être engendré un champ magnétique controllable, statique ou pouvant être modifié dans le temps.

Fig. 1a

Fig. 1b

Fig.2a

Fig.2b

Fig.2c

Fig.2d

Fig.2e

Fig.2f

EP 1 135 694 B1

Fig. 2

21

Fig. 3

Fig.4a

Fig.4b

Fig.4c

Fig. 4d

Fig. 5

Fig. 6

Fig.7

Fig. 8

Fig. 9 a

Fig. 9 b

Fig. 9 c

Fig.10a

Fig.10b

Fig.10c

Fig. 11 a

Fig. 11 b

Fig. 11 c

Fig. 11d

Fig. 12

Fig.13